(19) Europäisches Patentamt
European Patent Office
Office européen des brevets

(11) EP 0 694 911 B1

(12) **EUROPEAN PATENT SPECIFICATION**

(45) Date of publication and mention of the grant of the patent: **25.11.1998 Bulletin 1998/48**

(21) Application number: **95111915.5**

(22) Date of filing: **28.07.1995**

(51) Int Cl.[6]: **G11B 5/39**, H01F 10/08, H01F 10/00, H01F 10/26, H01F 10/30, H01L 43/08, C23C 14/00, G11B 5/31, G11B 5/187, H01L 43/10, G01R 33/09

(54) **Magnetic resistance type magnetic head for recording/reproducing**

Magnetowiderstandsmagnetkopf für Aufzeichnung und Wiedergabe

Tête à effet de magnétorésistance pour lecture et écriture

(84) Designated Contracting States:
**DE FR GB**

(30) Priority: **29.07.1994 JP 198018/94**

(43) Date of publication of application:
**31.01.1996 Bulletin 1996/05**

(73) Proprietor: **SONY CORPORATION**
**Tokyo (JP)**

(72) Inventors:
- **Kano, Hiroshi, c/o Sony Corporation Shinagawa-ku, Tokyo (JP)**
- **Okabe, Akihiro, c/o Sony Corporation Shinagawa-ku, Tokyo (JP)**
- **Nakano, Yuji, c/o Sony Corporation Shinagawa-ku, Tokyo (JP)**
- **Onuma, Kazunori, c/o Sony Corporation Shinagawa-ku, Tokyo (JP)**

(74) Representative: **Müller, Frithjof E., Dipl.-Ing.**
**Patentanwälte**
**MÜLLER & HOFFMANN,**
**Innere Wiener Strasse 17**
**81667 München (DE)**

(56) References cited:
**EP-A- 0 483 373**
**EP-A- 0 485 129**
**EP-A- 0 581 295**
**EP-A- 0 582 465**
**EP-A- 0 600 794**
**EP-A- 0 660 341**

- **PATENT ABSTRACTS OF JAPAN vol. 018 no. 466 (P-1794) ,30 August 1994 & JP-A-06 150259 (HITACHI LTD) 31 May 1994,**
- **PATENT ABSTRACTS OF JAPAN vol. 017 no. 311 (P-1556) ,14 June 1993 & JP-A-05 028436 (FUJITSU LTD) 5 February 1993,**
- **PATENT ABSTRACTS OF JAPAN vol. 011 no. 186 (P-586) ,16 June 1987 & JP-A-62 012913 (HITACHI LTD) 21 January 1987,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 694 911 B1

## Description

### BACKGROUND OF THE INVENTION

The present invention generally relates to magnetic resistance type magnetic heads. More specifically, the invention relates to a reproducing head and a composite type magnetic head for recording/reproducing for a magnetic sensor and magnetic recording equipment such as a magnetic disc unit, in which a magneto-resistance effect film having an artificial super-lattice film structure showing a giant magneto-resistance effect is used.

In recent years, the requirement for high density storage and high transport speed (i.e., read/write speed) has been increasing for magnetic recording equipment for computer back-up and the like. A multitrack magnetic resistance type magnetic head using a magnetic resistance element is widely being used as a means for achieving this requirement with sufficient reliability utilizing a relatively low magnetic tape running speed.

Figure 21 shows the basic and typical construction of such a device. In Figure 21, a magnetic resistance type magnetic head 1 has a ferromagnetic thin film such as permalloy (NiFe) and NiCo alloy formed as a magnetic resistance element on one substrate 2 of a pair of substrates 2 and 3 which form a magnetic shield. The head 1 is formed to have magneto-resistance effect films 6a, 6b, 6c--- of stripe form corresponding to a plurality of tracks 5a, 5b, 5c--- of the magnetic recording medium (e.g. magnetic tape) 4 by photolithography.

In this case, the respective magneto-resistance effect films 6a, 6b, 6c---are induced with uniaxial anisotropy by film-forming in a magnetic field or heat-treating in the magnetic field so that the axis of easy magnetization 10 is provided parallel to a track width direction. This is because an anisotropic magneto-resistance effect shown by a ferromagnetic thin film such as permalloy shows a resistance change depending on a relative angle of a detecting current and magnetization, and in the case where the axis of easy magnetization is disposed in a direction orthogonal to the track width, a sufficient magnetic resistance change is not obtained as shown in Figure 22.

The magnetic resistance element comprising the magneto-resistance effect film described above is disposed close to the magnetic layer 8 on the base film 7 of the magnetic recording medium 4, and the magnetization of the magnetic resistance element is changed by a magnetic field (leaked magnetic field) formed by recording signals from respective tracks of the magnetic layer 8. This in turn causes the resistance of the magnetic resistance element to change due to its magneto-resistance effect. In order to detect this resistance change, a detecting current to the magnetic resistance element is applied between pairs of electrodes 9a-9a', 9b-9b', 9c-9c'--- provided at both the ends of the magneto-resistance effect film. A detecting circuit (not illustrated) is connected to these electrodes, and the resistance change in the magnetic resistance element is detected thereby to read out signals stored in the magnetic recording medium 4.

The resistance of this magnetic resistance element changes with changes in an external magnetic field as shown in Figure 22. As shown on an enlarged scale in the detailed blow-up in Figure 21, for high sensitization of an output and linear response, a bias magnetic field is applied to the soft magnetic bias film 11 provided close to the magneto-resistance effect film orthogonally to a track width direction to shift a magnetic equilibrium point to a position B as shown in Figure 22.

However, there is a problem in the magnetic head as shown in Figure 21 in that as higher density recording is required and the track width becomes narrower, the leaked magnetic field decreases, and a sufficient reproductive output is not obtained. Accordingly, a ferromagnetic thin film material showing a large magnetic resistance change with a low magnetic field has been required.

For meeting this requirement, it has been found that an artificial lattice film prepared by laminating alternately a magnetic layer and a conductor layer shows a large magnetic resistance change, i.e., giant magneto-resistance effect (GMR).

For example, it is known that an artificial lattice film prepared by laminating Fe as the magnetic layer and Cr as the conductor layer exhibits a magnetic resistance change of about 50% by applying a magnetic field of 2T at a temperature of 4.2K. See, M. N. Baibich, et al., Phys. Rev. Lett. 61 (1988) 2472. Also, it is known that an artificial lattice film prepared by laminating Co having a thickness of 1.5 nm as the magnetic layer and Cu having a thickness of 0.9 nm as the conductor layer exhibits a magnetic resistance change of 48% by applying the magnetic field of 0.5T at a room temperature and that an artificial lattice film prepared by laminating Co having a thickness of 1.5 nm as the magnetic layer and Cu having a thickness of 2 nm as the conductor layer exhibits a magnetic resistance change of 19% by applying the magnetic field of 0.05T at a room temperature. See, D. H. Mosca, et al., Mag. Mag. Mat. 94 (1991) L1.

However, since all of these have large saturated magnetic fields of several KOe, the leaked magnetic field from the recording medium becomes as small from a few Oe to only tens of Oe (i.e., 0 to less than 100 Oe) corresponding to the narrowing of the track width. Accordingly, they could not be used for a magnetic resistance type magnetic head or a magnetic sensor.

It is known that in such an artificial lattice film, a large magnetic resistance change is obtained at a low magnetic field by inducing anisotropy into the film plane. See, K. Inomata, et al., Appl. Phys. Lett. 61 (1992) 726.

However, since an MgO single crystal substrate is used in order to induce anisotropy, the substrate is restricted, and there has been no freedom of selection of coefficient of thermal expansion, soft magnetic characteristic, machinability and sliding characteristic, all of which are considered important in a magnetic head substrate material.

Thus, various artificial lattice films have been formed in order to obtain a larger magnetic resistance change rate but defects frequently arose such that use thereof for a magnetic resistance type magnetic head or a magnetic sensor did not provide sufficient reproductive output and that since the saturated magnetic field is large and a large bias magnetic field is required, the bias current (accordingly, consumed electric power) increases too much.

In the EP-A-0 485 129 an artificial multilayer is disclosed in which ferromagnetic layers and nonmagnetic layers are alternatively laminated and wherein a uniaxial magnetic anisotropy is introduced into the ferromagnetic layers in a predetermined direction. It is furthermore taught there that the value of the saturated magnetic field depends on whether the external magnetic field is applied in or perpendicular to the direction of the easy axis of the artificial lattice material. This is reflected in the preambles of claims 1 and 2.

The JP-A-6150259 describes the fabrication of a magnetoresistive element having a multilayer laminated structure and to use such element in a magnetic head with detecting means for detecting the resistance change.

The EP-A-0 581 295 discloses a magnetoresistance film with an artificial lattice film structure having alternating conductive and magnetic layers. It is taught therein that the anisotropic magnetic field of the magnetic layers and the anti-ferromagnetic coupling magnetic field between the magnetic layers which face each other through the conductive layers should satisfy a specific relationship.

The EP-A-0 660 341, which is prior art according to Art.54(3) EPC, describes an artificial lattice film, which is constituted as multilayered film in which magnetic layers containing Cu of 1 - 50 atomic percentage and at least one component from Fe, Ni and Co and conductive layers are stacked one after another. It also teaches a fabrication method wherein a substrate onto which a magneto-resistance effect layer is to be formed, is fixed on a support and the support is rotated while forming the magneto-resistance effect layer.

An object of the present invention is to provide a magnetic resistance type magnetic head, particularly a multitrack head, which exhibits a large magnetic resistance change in response to a small leaked magnetic field and which has a magneto-resistance effect film providing a regenerative wave form having good symmetry with a small bias current. Another object is to provide a composite type magnetic head for recording/reproducing using this magnetic resistance type magnetic head as a reproducing head.

The present inventors have found that where the magneto-resistance effect layer or magneto-resistance effect film is formed from an artificial lattice material, particularly a ferromagnetic metal artificial lattice material, an axis of easy magnetization in the artificial lattice material oriented orthogonally with respect to a track width direction not only causes the magnetic resistance change rate per applied magnetic field unit to decrease and the reproductive output to decrease but also allows the optimum bias magnetic field to grow and consume more bias current, and the present invention has been devised based on this finding.

In an embodiment, the present invention provides a magnetic resistance type magnetic head having a magneto-resistance effect layer comprising an artificial lattice material, and a detecting means for detecting a resistance change in this magneto-resistance effect layer, wherein these magneto-resistance effect layer and detecting means are disposed so that signals recorded on tracks of a magnetic recording medium are detected, and an axis of easy magnetization in the magneto-resistance effect layer crosses a width direction of the above tracks (i.e., orthogonal to the medium). The magneto-resistance effect layer or magneto-resistance effect film is formed by an artificial lattice obtained by alternately laminating a magnetic layer and a conductor layer and the above magnetic layer contains copper (Cu) of 1 to 50 atomic % and contains at least one selected from the group consisting of iron (Fe), cobalt (Co) and nickel (Ni).

It has been found that according to the magnetic resistance type magnetic head of the present invention, since the axis of easy magnetization in the magneto-resistance effect layer comprising the artificial lattice material crosses the width direction of the tracks, a magnetic resistance change rate per an applied magnetic field unit is increased, and a large magnetic resistance change is exhibited with a change in a minute leaked magnetic field and that not only the reproductive output is improved but also a regenerative wave form having good symmetry can be obtained with a small bias current.

Preferably, a plurality of sets of the magneto-resistance effect film comprising a ferromagnetic metal artificial lattice material and a pair of electrodes for detecting a resistance change in this magneto-resistance effect film are provided in the magnetic resistance type magnetic head of the present invention for multitrack use so that they each detect signals recorded on a plurality of tracks of the magnetic recording medium and that the axis of easy magnetization in the above magneto-resistance effect film is substantially orthogonal to the width direction of the above tracks.

A Cu content in the magnetic layer less than the range described above cannot provide a sufficient magnetic resistance change rate and increases a coercive force. On the other hand, too much Cu reduces the effect of increasing the magnetic resistance change rate. Fe, Ni and Co each contained in this magnetic layer are preferably controlled in the composition ratio thereof as shown below in order to improve the sensitivity to an external magnetic field:

$Fe_xCO_yNi_z$ (x, y and z in terms of atomic %)

where:

$10 \leq x \leq 25$, $30 \leq y \leq 80$, $10 \leq z \leq 50$ and $x + y + z = 100$

On the other hand, with respect to the conductor layer described above, Cu and Cr, which have so far been used as the conductor layer for an artificial lattice film, can be used, and the film thickness thereof is preferably 1.8 to 2.8 nm. The magnetic resistance change rate is varied as well depending on the film thickness of the conductor layer, and a film thickness that is too much thinner or too much thicker than the range described above reduces the magnetic resistance change rate. For example, a film thickness of the conductor layer controlled to 0.9 nm provides a magnetic resistance change rate of about 50% but increases the saturated magnetic field, and a uniaxial anisotropy at a level of some tens of Oe which is obtained by the film-forming method and equipment according to the present invention does not sufficiently effect of an increase in the magnetic resistance change rate per applied magnetic field unit and reduction in the bias magnetic field.

In an embodiment of the present invention, a soft magnetic bias layer and a pair of electrodes for applying an electric current to this soft magnetic bias layer are provided in order to apply a bias magnetic field to the magneto-resistance effect layer or magneto-resistance effect film.

Further, in an embodiment, the present invention provides a composite type magnetic head for recording/reproducing which is constructed by combining a reproducing head comprising the above magnetic resistance type magnetic head according to the present invention and a recording head.

In order to produce the magnetic resistance type magnetic head and the composite type magnetic head for recording/reproducing it is preferred that a substrate on which the magneto-resistance effect layer or magneto-resistance effect film is formed is fixed on a support, and the above film formation is carried out while rotating this support, and that a direction which becomes a width direction of the tracks of a magnetic recording medium is allowed to be aligned with a rotating circumferential direction of the above support during this film formation to fix the above substrate on the support.

In this case, it is preferred that a substrate on which the magneto-resistance effect layer or magneto-resistance effect film having uniaxial anisotropy in a plane of the layer or film is formed is fixed on the support and that this support is allowed to pass in the vicinity of a flying source (e.g. a target for sputtering, a deposition source or an ion-generating source for ion plating) for an artificial lattice material while rotating the support to carry out the film formation. Any conventional film-forming method can be used for the magnetic layer and the conductor layer described above. Suitable methods include, for example, vacuum deposition, sputtering and ion plating, and the film formation preferably is carried out by sputtering using a target having the composition ratio described above.

In this case, in order to accurately control the film thicknesses of the magnetic layer and the conductor layer and to induce a uniaxial anisotropy into a plane of the magneto-resistance effect layer or magneto-resistance effect film, the alternate film formation can be carried out while rotating the substrate on the targets for the magnetic layer and the conductor layer, and the film formation can be carried out as necessary while applying a magnetic field in a direction of an axis of easy magnetization (i.e. a rotating radial direction). As this allows the axis of easy magnetization in an artificial lattice film to be induced to a rotating radial direction of the substrate, the axis of easy magnetization is made orthogonal to a track width direction by fixing the track width direction aligned with a rotating circumferential direction, and a magneto-resistance effect element exhibiting a large magnetic resistance change rate with a small bias current can readily be prepared.

It is generally known as a film-forming method for minutely controlling the thicknesses of the magnetic layer and the conductor layer to allow a substrate to stand still alternately on a target for deposition or sputtering and to control the timing with which a shutter is opened and closed. However, a uniaxial anisotropy cannot be induced into a film plane by such a method. Further, in this method, combined use of a film-forming method in which the film formation is carried out in a magnetic field by applying the magnetic field to the substrate can not induce sufficient anisotropy.

In particular, the production method described in the present application preferably comprises the steps of: forming a track width-controlling layer for controlling the track width on the substrate; forming a soft magnetic bias layer, a separating intermediate layer and the magneto-resistance effect layer or magneto-resistance effect film in order on the substrate containing this track width-controlling layer; forming a pair of electrodes for detecting resistance change on the magneto-resistance effect layer or magneto-resistance effect film at both sides of the track width-controlling layer; and providing an insulating layer for forming magnetic gaps on the substrate at these electrode sides. Further, it is preferred that after integrating with the substrate an opposed substrate on which the insulating layer for forming magnetic gaps has been formed, a magnetic head chip is cut, and a magnetic recording medium sliding plane is processed.

In an embodiment of the production method, the artificial lattice film described above is formed on a magnetic substrate such as single crystal ferrite constituting a magnetic shield via an insulating layer which becomes a magnetic gap. The formed artificial lattice film is molded by photolithography to a magnetic resistance element of a stripe form in which an axis of easy magnetization crosses orthogonally the track width direction. In this case, a structure for applying a bias magnetic field (a bias conductor layer, a shunt layer, a soft magnetic bias layer and the like) is sometimes formed directly above or below the magnetic resistance element part. After forming electrodes for introducing a detecting current at both ends of the magnetic resistance element part, the opposed magnetic shield layers can be adhered to constitute a multitrack magnetic resistance type magnetic head.

These and other features of the invention are discussed in greater detail below in the following detailed description of the presently preferred embodiments with reference to the accompanying drawings.

## BRIEF DESCRIPTION OF THE DRAWINGS

Figure 1 is a schematic perspective view illustrating a use state of the multitrack magnetic resistance type magnetic head according to an embodiment of the present invention.

Figure 2 is a cross-sectional perspective view illustrating a part of the multitrack magnetic resistance type magnetic head described above.

Figure 3 is a cross-sectional perspective view of selected portions of the part of the multitrack magnetic resistance type magnetic head of Figure 2.

Figure 4 is a cross-section of the element of Figure 2 taken generally along the line IV-IV.

Figure 5 is a perspective view of a recording/reproducing composite type multitrack head both in disassembled and assembled form after assembly, in which the multitrack magnetic resistance type magnetic head described herein is used.

Figure 6 is a cross-sectional diagram of one example of an artificial lattice film used for the multitrack magnetic resistance type magnetic head described herein.

Figure 7 is a schematic perspective view of a sputtering device used for producing the artificial lattice film provided on the magnetic head described herein.

Figure 8 is a characteristic plot showing external magnetic field dependency of magnetic resistance change in the case where an axis of easy magnetization in the artificial lattice film is crossed orthogonally to a track width direction.

Figure 9 is a characteristic plot showing external magnetic field dependency of magnetic resistance change in the case where the axis of easy magnetization in an artificial lattice film is allowed to be aligned with the track width direction.

Figures 10-16 are a series of perspective views showing process steps of a method for producing a multitrack magnetic resistance type magnetic head using an artificial lattice film according to the present invention.

Figure 17 is a characteristic plot showing detecting current dependency on symmetry in a reproductive wave form in the multitrack magnetic resistance type magnetic head using an artificial lattice film according to the present invention.

Figure 18 is a characteristic plot showing for comparison purposes the recording frequency dependencies of the multitrack magnetic resistance type magnetic head using an artificial lattice film according to the present invention and the multitrack magnetic resistance type magnetic head using conventional permalloy.

Figure 19 is a characteristic plot showing external magnetic field dependency of a magnetic resistance change rate of an artificial lattice film of the present invention formed by allowing a substrate to pass on a sputtering target while rotating it.

Figure 20 is a characteristic plot showing external magnetic field dependency of the magnetic resistance change rate of an artificial lattice film formed by allowing a substrate to stand still on a sputtering target and controlling a film thickness by opening and closing a shutter.

Figure 21 is a schematic perspective view showing a conventional multitrack magnetic resistance type magnetic head.

Figure 22 is a characteristic plot for explaining an anisotropic magneto-resistance effect.

## DETAILED DESCRIPTION OF THE PRESENTLY PREFERRED EMBODIMENT

Examples of the present invention are explained below with reference to Figures 1-20. Figures 1-20 show examples in which the present invention was applied to a multitrack magnetic resistance type magnetic head.

### Preparation of the magneto-resistance effect element and characteristics evaluation thereof:

The present inventors investigated the dependency of the magnetic resistance change rate on an external magnetic field in cases where an axis of easy magnetization in an artificial lattice film extends orthogonally with respect to a track width direction and where it extends parallel thereto.

An artificial lattice film 16 used herein was prepared by laminating on a glass substrate 28 alternately, for example, each 10 layers of a magnetic layer 16A comprising $(Fe_{20}Co_{35}Ni_{45})_{80}Cu_{20}$ and having a film thickness of 1.0 nm for one layer and a conductive layer 16B comprising Cu and having a film thickness of 2.1 nm for one layer.

This artificial lattice film 16 was formed with DC magnetron sputtering equipment. In this sputtering equipment, provided in a chamber 27 as shown in Figure 7 are a substrate holder 21 for holding substrate 20 for a magnetic head, a rotation axis 22 for rotating this substrate holder 21 (accordingly, the substrate 20 for the magnetic head), a target 23 comprising $(Fe_{20}Co_{35}Ni_{45})_{80}Cu_{20}$, a target 24 comprising Cu, and shutters 25 and 26 for controlling start and stop of film formation of the substrate 28 for the magnetic head. Further, though not illustrated, provided in the chamber 27 are a DC magnet in the vicinity of the sputter targets, and an introduction port for sputter gas and an exhaust port on a chamber wall for exhausting vapor and atmosphere.

In order to form the artificial lattice film 16 with this sputter equipment, the glass substrate 28 was fixed on the rotational substrate holder 21 cooled with water, and the $(Fe_{20}Co_{35}Ni_{45})_{80}Cu_{20}$, target 23 for the magnetic layer and the Cu target 24 for the conductor layer were sputtered while maintaining the gas pressure at 0.5 Pa by introducing Ar gas after pre-exhausting the film-forming bath 27 (chamber) up to 1 x $10^{-4}$ Pa. In this case, the glass substrate 28 was rotated to pass it alternately on the target 23 for the magnetic layer and the target 24 for the conductor layer (the shutter was opened in passing and closed in non-passing), whereby the artificial lattice film 16 was formed as shown in Figure 6.

The magnetic layer 16A and the conductor layer 16B of the artificial lattice film 16 were formed to the prescribed thicknesses, respectively, by controlling the sputter discharge current. Uniaxial anisotropy was induced into a plane of the substrate 28 by carrying out film formation while rotating the substrate 28, and the axis of easy magnetization 20 was aligned with a rotating radial direction of the substrate. That is, the substrate 28 was fixed on the holder 21 so that the track width direction in the magnetic recording medium was aligned with a rotating circumferential direction in the holder 21, and the film formation described above was carried out while continuously rotating the substrate. The result thereof led to a finding that the axis of easy magnetization 20 in the magnetic layer 16A thus obtained was turned to a rotating radial direction.

The artificial lattice film 16 thus formed was photolithographically processed into a magneto-resistance effect element having a magnet-sensitive area of 5 μm x 20 μm. The major side is the 20 μm side direction of this element corresponds to a track width of the magnetic resistance type magnetic head.

After forming the electrodes at both the sides of the element, dependency of the resistance value on the applied magnetic field was measured by a direct current four-terminal method. A 300 Oe magnetic field was applied in a direction orthogonal to the track width, and a magnetic resistance change rate was calculated from a resistance value R in applying the magnetic field and a resistance value Rs in applying 300 Oe using the following equation:

$$\Delta R = (R - Rs)/Rs$$

Figure 8 shows the dependency of the magnetic resistance change rate on the external magnetic field in the case where the axis of easy magnetization 20 crosses orthogonally the track width direction. Unlike the case of permalloy shown in Figure 22, a large magnetic resistance change rate is obtained. In addition, since a steep change in the magnetic resistance is obtained with a low magnetic field, a magnetic resistance type magnetic head which provides a large output with a small bias magnetic field of a level of 15 Oe can be produced.

On the other hand, shown in Figure 9 is the dependency of the magnetic resistance change rate on the external magnetic field in the case where the axis of easy magnetization in the artificial lattice film formed in the same manner as described above was made to be aligned with the track width direction. Since the change in the magnetic resistance to the external magnetic field is gentle, the magnetic resistance type magnetic head produced therewith does not provide a sufficient reproductive output. Further, since the optimum bias magnetic field also is as large as 35 Oe, the bias current becomes too large.

Production of a multitrack magnetic resistance type magnetic head and characteristics evaluation thereof:

Next, a multitrack magnetic resistance type magnetic head having a magneto-resistive part formed with an artificial lattice film was produced and subjected to a signal reproduction test. One example of the production processes for the multitrack magnetic resistance type magnetic head will be explained with reference to Figures 10-16.

First of all, in order to form a magnetic shield as shown in Figure 10, an Ni-Zn single crystal ferrite substrate is prepared as the substrate 30.

Then, as shown in Figure 11, the concave part 31 for avoiding an influence of a level difference caused by a thickness at the electrode-take out part is formed to a depth of 0.3 μm by a first ion milling.

Next, as shown in Figure 12, after the concave part 32 for avoiding an influence of a level difference caused by a thickness at the electrode-take out part from both sides of a magneto-sensitive part is formed to a depth of 0.1 μm by a second ion milling, and a $SiO_2$ insulating layer 28 for forming magnetic gaps is formed to a depth of 0.25 μm by sputtering. The central convex part 35 caused to remain in an island form by the concave 32 regulates the track width.

Then, as shown in Figure 13, in order to apply a bias magnetic field to the magneto-sensitive part, a CoZrMoPd amorphous film 33 is formed as a soft magnetic bias layer to a thickness of 70 nm, and a Ti film 34 as a separating intermediate layer to a thickness of 30 nm. The CoZrMoPd amorphous film 33 is induced with anisotropy in the track width direction by heat treatment in a magnetic field.

The substrate 30 is fixed on the holder 21 with the track width direction being aligned with the rotating circumferential direction, and the artificial lattice film 16 as shown in Figure 6 is formed as a laminated film of the magnetic layer 16A and the conductor layer 16B in ten cycles by the same method as described in Figure 7. This artificial lattice film 16 has the axis of easy magnetization extending orthogonally to the track width direction.

Thereafter, the three-layer structure of the soil magnetic bias layer 33/separating intermediate layer 34/artificial lattice layer 16 is processed in a stripe width of 7 μm form with photolithography to form the magneto-sensitive part 36 having an element width of 7 μm.

Then, as shown in Figure 14, a pair of electrodes 39 and 39' are formed by an Mo film having a thickness of 0.1 μm at both ends of the magneto-sensitive part 36 to control a track width of the magneto-sensitive part to 76.2 μm. These electrodes can be formed with good accuracy by photolithography after wholly sputtering with Mo.

Next, as shown in Figure 15, pullout electrodes 40 and 40' having a Ti/Cu/Ti structure are formed by a Cu film having a thickness of 0.3 μm via an adhesive layer suitable for Ti.

Figure 16 is a general drawing which shows a state of the multitrack magnetic resistance type magnetic head wafer 41 thus prepared before adhering thereto of an opposed magnetic shielding-substrate.

Then, as shown in Figure 2, after the $SiO_2$ insulating layer 43 for forming a magnetic gap is formed on the opposed magnetic shielding-Ni-Zn single crystal ferrite substrate 42, it is adhered on the head wafer 41 shown in Figure 16.

Next, after cutting by every chip, sliding planes (refer to Figure 16) are polished to expose the magneto-sensitive parts. A part (one track portion) of the multitrack magnetic resistance type magnetic head 51 thus prepared is shown in Figures 2-4.

That is, Figure 2 shows one track portion of the multitrack magnetic resistance type magnetic head 51. The three-layer structure film of the soft magnetic bias layer 33/separating intermediate layer 34/artificial lattice layer 16 described above is deposited on the convex part 35 regulating the track width in the track width direction, and the electrodes 39 and 39' for detecting a current for the artificial lattice layer 16 and second leads (electrodes) 40 and 40' are provided at both the sides of the convex part 35.

Figure 1 schematically shows a use state of the multitrack magnetic resistance type magnetic head 51 prepared in the manner described above, and it is fundamentally different from that shown in Figure 21 in that the artificial lattice film 16 is used as a magneto-resistance effect film and that the axis of easy magnetization 20 in the artificial lattice film 16 extends orthogonally with respect to the track width direction.

Figure 5 shows an example in which this multitrack magnetic resistance type magnetic head is adhered adjusting a track center with a pair of MR heads 51A and 51B used for reproduction and the multitrack thin film recording head 52 used for recording, whereby the recording/reproducing composite type magnetic head 61 is formed.

The thin film recording head 52 used for this composite type magnetic head 61 may be one obtained by processing a soft magnetic film formed on the non-magnetic substrate 54 by photolithography to form the lower core 56, forming the Cu thin film coil 70 via the insulating film 60 forming a magnetic gap by an electroplating method, and forming the upper core 55 (53 is the non-magnetic substrate or layer) after forming once again an insulating film (in the drawing, 57 and 58 are guard materials and 59 is a magnetic shield ring). In this case, since the magnetic resistance type magnetic heads 51A and 51B according to the present invention are built in adjusting to a track center, even a minute magnetic field can stably be detected at a high output, and it is useful for high density and high transportation speed for multitrack.

Next, this composite type head 61 was used to record signals on a magnetic tape while changing the frequency to check change in the reproductive output. The recording/reproducing conditions were as follows:

magnetic tape: Co-$\gamma$-$Fe_2O_3$ coating type medium having a width of 1/4 inch
tape speed: 1 m/sec
recording track width: 177.8 μm
reproducing track width: 76.2 μm
detecting current at reproducing side: 12 mA.

Figure 17 shows detecting current dependency of symmetry in a reproductive wave form. Since a soil adjacent layer (SAL) bias structure in which a soil magnetic bias film is allowed to be adjacent to the artificial lattice film is employed in the present invention, the detecting current is aligned with the bias current. In this drawing, the symmetry of the reproductive wave form becomes best when A/B = 1 . In the multitrack magnetic resistance type magnetic head in the examples of the present invention, a reproductive wave form having good symmetry is obtained at 12 to 16 mA, and an optimum bias point is obtained at a wide area of a low current.

Recording frequency dependency of a reproductive output voltage in the multitrack magnetic resistance type magnetic head using the artificial lattice film is shown in Figure 18 together with a comparative multitrack magnetic resistance type magnetic head prepared by using the permalloy film described above. It can be seen that the multitrack magnetic resistance type magnetic head using the artificial lattice film provides a larger reproductive output in all frequency ranges.

Next, a multitrack magnetic resistance type magnetic head having a magneto-sensitive part which is formed by permalloy was prepared for comparison purposes in a signal reproduction test.

The production processes of this multitrack magnetic resistance type magnetic head are the same as those described above and shown in Figures 10-16. In forming the magneto-sensitive part, anisotropy was induced in a track width direction by heat treatment in a magnetic field after forming a CoZrMoPd amorphous film as a soft magnetic bias layer in 70 nm, Ti as a separating intermediate layer in 30 nm and finally permalloy in 30 nm.

The multitrack magnetic resistance type magnetic head of a comparative example prepared by such processes was used to evaluate the recording frequency dependency of a reproductive signal voltage in the same conditions as those described above. The results are shown in Figure 18, and it can be seen that the reproductive signal voltage of the magnetic head of the comparative example does not reach that of the multitrack magnetic resistance type magnetic head using the artificial lattice film of the present invention throughout the entire frequency range.

Next, the relationship of the film forming method used for the artificial lattice film to the magnetic anisotropy induced into a plane was investigated. A glass substrate was fixed on a rotating substrate holder, and this was passed alternately on a sputter target for a magnetic layer and the sputter target for a conductor layer in the same conditions as those described above while rotating at a fixed rotational speed, to thereby form an artificial lattice film. The thicknesses of the respective layers were controlled by the sputter discharge current.

A sample was cut out in a size of 8 mm x 25 mm and then a magnetic field was applied thereto in a rotating radial direction or circumferential direction of the substrate. A magnetic resistance change rate measured while applying a current parallel to the magnetic field is shown in Figure 19. It can be seen that an axis of easy magnetization is induced in the rotating radial direction and that a steep magnetic resistance change is obtained at a low magnetic field.

On the other hand, another glass substrate was fixed on the substrate holder, and this was allowed to stand still alternately on the sputter target for the magnetic layer and the sputter target for the conductor layer to form the artificial lattice film while controlling the thicknesses of the respective layers by the open/close times.

The result obtained by evaluating this in the same manner as that described above is shown in Figure 20. In this case, since the film has no anisotropy (is not shown) in the film's plane, and a steep magnetic resistance change is not obtained at the low magnetic field as described above, this film is inadequate to be applied to a highly sensitive magnetic resistance element.

Further, the relationship of the alloy composition of the magnetic layer in the artificial lattice film to the axis of easy magnetization induced into the artificial lattice film by rotational film formation was investigated.

The alloy composition of the magnetic layer in the artificial lattice film (formed in the same conditions as those described above in connection with Figure 19) and the direction of the axis of easy magnetization are summarized in the following Table 1. Since the axis of easy magnetization is aligned with a rotating radial direction of the substrate regardless of the composition of the magnetic layer, by applying the rotational film formation to the artificial lattice film according to the present invention, the axis of easy magnetization after the film formation can readily be anticipated.

On the other hand, an alloy composition and a direction of an axis of easy magnetization obtained when only a magnetic layer (a magnetic single layer film: no conductor layer) having the same composition as that described above is prepared by the rotational film formation are shown in Table 1. The direction of the axis of easy magnetization has been changed according to the composition of the magnetic layer, and the direction thereof cannot accurately be anticipated while anisotropy can be induced by the rotational film formation.

Table 1

| Alloy composition in the magnetic layer | Axis of easy magnetization direction* | Axis of easy magnetization direction** |
|---|---|---|
| $(Fe_{24}Co_{58}Ni_{30})_{80}Cu_{20}$ | Radial direction | Circumferential direction |
| $(Fe_{12}Co_{28}Ni_{80})_{70}Cu_{30}$ | Radial direction | Radial direction |
| $(Fe_{21}Co_{49}Ni_{30})_{90}Cu_{10}$ | Radial direction | Radial direction |
| $(Fe_{15}Co_{35}Ni_{50})_{60}Cu_{40}$ | Radial direction | Radial direction |

* Artificial lattice film according to the present invention.

** In the case where only the magnetic layer is formed.

The present invention was explained above, and the examples described above can further be modified based on the technical concept of the present invention.

For example, the direction of the axis of easy magnetization in the artificial lattice film described preferably substantially extends orthogonally to a track width direction but it may not extend completely orthogonally, and crossing at a fixed angle (preferably 45° or more, particularly 80° to 90°) is effective as well.

The construction may be made so that correspondence to at least two adjacent tracks is possible as a multitrack magnetic resistance type magnetic head but a weak leaked magnetic field also can sufficiently be detected even with many tracks. Further, in case of a composite head, a recording head to be combined may be of a type other than those described above.

The artificial lattice film may variously be changed in the thickness of each layer and the material as well as the lamination number thereof. With respect to the conductor layer, the material therefor may be Ag, Ru or a mixture thereof as well as Cu and Cr. A bias system may be a conductor bias system.

The film-forming method therefor may be a sputtering method other than magnetron sputtering or a vacuum deposition method and an ion plating method, and accordingly, the flying source may be a target, a deposition source or an ion-generating source.

As described above, since the present invention employs a magnetic resistance type magnetic head having a magneto-resistance effect layer comprising an artificial lattice material and a detecting means for detecting a resistance change in this magneto-resistance effect layer, wherein these magneto-resistance effect layer and the detecting means are disposed so that they detect signals recorded on tracks of a magnetic recording medium, and an axis of easy magnetization in the above magneto-resistance effect layer is oriented orthogonally with respect to a width direction of the above tracks, and a recording/reproducing composite type magnetic head using this magnetic head for reproduction, the present invention can provide a magnetic head which shows a large magnetic resistance change with a change in a minute leaked magnetic field from the magnetic recording medium and which provides a reproductive wave form having good symmetry with a small bias current and is useful as a multitrack magnetic resistance type magnetic head.

Since a substrate on which a magneto-resistance effect layer or a magneto-resistance effect film is formed is fixed on a support to carry out the above film formation while rotating this support and in this film formation the above substrate is fixed on the above support allowing a direction which becomes a width direction of tracks in a magnetic recording medium to be aligned with a rotating circumferential direction of the above support, magnetic anisotropy can readily be provided in a fixed direction (a direction crossing the track width direction) without depending on the compositions of the substrate material and the magnetic layer.

Although modifications and changes may be suggested by those skilled in the art, it is the intention of the inventors to embody within the patent warranted hereon all changes and modifications as reasonably and properly come within the scope of the claims.

## Claims

1. A magnetic resistance type magnetic head (51) for reproducing signals recorded in one or more tracks (5a, 5b, 5c) on a recording medium (4), comprising:
   a magneto-resistance effect layer (16) comprising an artificial lattice material; and detecting means for detecting a resistance change in the magneto-resistance effect layer, wherein the magneto-resistance effect layer and detecting means are disposed such that signals recorded on the track of the magnetic recording medium are detected and an axis of easy magnetization in said magneto-resistance effect layer crosses a width direction of said one or more tracks, and wherein the magneto-resistance effect layer (16) is formed by an artificial lattice obtained by alternately laminating a magnetic layer (16A) and a conductor layer (16B),
   **characterized in that**
   the magnetic layer (16A) contains copper of 1 to 50 atomic % and contains at least one selected from a group consisting of iron, cobalt and nickel.

2. A composite type magnetic head (61) for recording/reproducing, comprising a recording head (52) and a magnetic resistance type magnetic head (51A, 51B) for reproducing signals recorded in one or more tracks (5a, 5b, 5c) on a recording medium (4), comprising:
   a magneto-resistance effect layer (16) comprising an artificial lattice material; and detecting means for detecting a resistance change in the magneto-resistance effect layer, wherein the magneto-resistance effect layer and detecting means are disposed such that signals recorded on the track of the magnetic recording medium are detected and an axis of easy magnetization in said magneto-resistance effect layer crosses a width direction of said one or more tracks. and wherein the magneto-resistance effect layer (16) is formed by an artificial lattice obtained by alternately laminating a magnetic layer (16A) and a conductor layer (16B),

**characterized in that**
the magnetic layer (16A) contains copper of 1 to 50 atomic % and contains at least one selected from a group consisting of iron, cobalt and nickel.

3. The magnetic head according to claim 1 or the composite type magnetic head according to claim 2, comprising a plurality of sets of magneto-resistance effect films for multitrack operation, each set comprising a ferromagnetic metal artificial lattice material and a pair of electrodes for detecting a resistance change in this magneto-resistance effect film, each set detecting signals recorded on a respective plurality of tracks of the magnetic recording medium and having an axis of easy magnetization in said magneto-resistance effect film that is substantially orthogonal to the width direction of said tracks.

4. The magnetic head according to claim 1 or the composite type magnetic head according to claim 2, wherein the conductor layer has a thickness of 1,8 to 2,8 nm.

5. The magnetic head according to claim 1 or the composite type magnetic head according to claim 2, including a soft magnetic bias layer (33) and a pair of electrodes (39a,39a',39b,39b',39c,39c') for applying an electric current to this soft magnetic bias layer such that a bias magnetic field can be applied to the magneto-resistance effect layer.

## Patentansprüche

1. Magnetowiderstands-Magnetkopf (51) zum Wiedergeben von Signalen, die in einer oder mehreren Spuren (5a, 5b, 5c) auf einem Aufzeichnungsmedium (4) aufgezeichnet sind, aufweisend:
eine Magnetowiderstandseffekt-Schicht (16) aufweisend ein artifizielles Gittermaterial; und Detektionsmittel zum Detektieren einer Widerstandsänderung in der Magnetowiderstandseffekt-Schicht, wobei die Magnetowiderstandseffekt-Schicht und die Detektionsmittel derart angeordnet sind, daß auf der Spur des magnetischen Aufzeichnungsmediums aufgezeichnete Signale detektiert werden und eine Achse der leichten Magnetisierung in der Magnetowiderstandseffekt-Schicht eine Quer- oder Breitenrichtung der einen oder mehreren Spuren kreuzt, und wobei die Magnetowiderstandseffekt-Schicht (16) durch ein artifizielles Gitter gebildet ist, welches durch alternierendes Aufschichten einer magnetischen Schicht (16A) und einer leitfähigen Schicht (16B) erhalten wird,
**dadurch gekennzeichnet, daß**
die magnetische Schicht (16A) 1 bis 50 Atom-% Kupfer enthält und mindestens einen Bestandteil enthält, der aus der Gruppe bestehend aus Eisen, Kobalt und Nickel ausgewählt ist.

2. Verbundtyp-Magnetkopf (61) zum Aufzeichnen/Wiedergeben, aufweisend einen Aufzeichnungskopf (52) und einen Magnetowiderstands-Magnetkopf (51A, 51B) zum Wiedergeben von Signalen, die in einer oder mehreren Spuren (5a, 5b, 5c) auf einem Aufzeichnungsmedium (4) aufgezeichnet sind, aufweisend:
eine Magnetowiderstandseffekt-Schicht (16) aufweisend ein artifizielles Gittermaterial; und Detektionsmittel zum Detektieren einer Widerstandsänderung in der Magnetowiderstandseffekt-Schicht, wobei die Magnetowiderstandseffekt-Schicht und die Detektionsmittel derart angeordnet sind, daß auf der Spur des magnetischen Aufzeichnungsmediums aufgezeichnete Signale detektiert werden und eine Achse der leichten Magnetisierung in der Magnetowiderstandseffekt-Schicht eine Quer- oder Breitenrichtung der einen oder mehreren Spuren kreuzt, und wobei die Magnetowiderstandseffekt-Schicht (16) durch ein artifizielles Gitter gebildet ist, welches durch alternierendes Aufschichten von einer magnetischen Schicht (16A) und einer leitfähigen Schicht (16B) erhalten wird,
**dadurch gekennzeichnet, daß**
die magnetische Schicht (16A) 1 bis 50 Atom-% Kupfer enthält und mindestens einen Bestandteil enthält, der aus der Gruppe bestehend aus Eisen, Kobalt und Nickel ausgewählt ist.

3. Magnetkopf nach Anspruch 1 oder Verbundtyp-Magnetkopf nach Anspruch 2, aufweisend eine Mehrzahl von Sätzen von Magnetowiderstandseffekt-Filmen für den Vielspurbetrieb, wobei jeder Satz ein ferromagnetisches metallisches artifizielles Gittermaterial und ein Paar von Elektroden zum Detektieren einer Widerstandsänderung in diesem Magnetowiderstandseffekt-Film aufweist, und jeder Satz Signale detektiert, die auf einer entsprechenden Mehrzahl von Spuren des magnetischen Aufzeichnungsmediums aufgezeichnet sind, und eine Achse der leichten Magnetisierung in dem Magnetowiderstandseffekt-Film aufweist, die im wesentlichen zu der Quer- oder Breitenrichtung der Spuren orthogonal ist.

4. Magnetkopf nach Anspruch 1 oder Verbundtyp-Magnetkopf nach Anspruch 2, bei welchem die leitfähige Schicht eine Dicke von 1,8 bis 2,8 nm aufweist.

5. Magnetkopf nach Anspruch 1 oder Verbundtyp-Magnetkopf nach Anspruch 2, enthaltend eine weichmagnetische Vormagnetisierungsschicht (33) und ein Paar von Elektroden (39a, 39a' 39b, 39b', 39c, 39c') zum Anlegen eines elektrischen Stroms an diese weichmagnetische Vormagnetisierungsschicht derart, daß ein Vormagnetisierungsfeld an die Magnetowiderstandseffekt-Schicht angelegt werden kann.

**Revendications**

1. Tête magnétique de type à résistance magnétique (51) pour reproduire des signaux enregistrés sur une ou plusieurs pistes (5a, 5b, 5c) sur un support d'enregistrement (4), comprenant :

   une couche à effet de magnétorésistance (16) comprenant un matériau à réseau synthétique ; et,
   un moyen de détection pour détecter une variation de résistance dans la couche à effet de magnétorésistance, dans laquelle la couche à effet de magnétorésistance et le moyen de détection sont disposés pour que les signaux enregistrés sur la piste du support d'enregistrement magnétique soient détectés et qu'un axe d'aimantation facile dans ladite couche à effet de magnétorésistance coupe une direction de largeur desdites une ou plusieurs pistes, et dans laquelle la couche à effet de magnétorésistance (16) est constituée par un réseau synthétique obtenu en laminant alternativement une couche magnétique (16A) et une couche conductrice (16B),

   caractérisée en ce que la couche magnétique (16A) contient 1 à 50 % d'atomes de cuivre et contient au moins un composant sélectionné dans un groupe composé de fer, de cobalt et de nickel.

2. Tête magnétique d'enregistrement/reproduction de type composite (61), comprenant une tête d'enregistrement (52) et une tête magnétique de type à résistance magnétique (51A, 51B) pour reproduire des signaux enregistrés sur une ou plusieurs pistes (5a, 5b, 5c) sur un support d'enregistrement (4), comprenant :

   une couche à effet de magnétorésistance (16) comprenant un matériau à réseau synthétique ; et,
   un moyen de détection pour détecter une variation de résistance dans la couche à effet de magnétorésistance, dans laquelle la couche à effet de magnétorésistance et le moyen de détection sont disposés pour que des signaux enregistrés sur la piste du support d'enregistrement magnétique soient détectés et qu'un axe d'aimantation facile dans ladite couche à effet de magnétorésistance coupe une direction de largeur desdites une ou plusieurs pistes, et dans laquelle la couche à effet de magnétorésistance (16) est constituée par un réseau synthétique obtenu en laminant alternativement une couche magnétique (16A) et une couche conductrice (16B),

   caractérisée en ce que la couche magnétique (16A) contient 1 à 50 % d'atomes de cuivre et contient au moins un composant sélectionné dans un groupe composé de fer, de cobalt et de nickel.

3. Tête magnétique selon la revendication 1 ou tête magnétique de type composite selon la revendication 2, comprenant une pluralité d'ensembles de films à effet de magnétorésistance pour un fonctionnement sur plusieurs pistes, chaque ensemble comprenant un matériau à réseau synthétique de métal ferromagnétique et une paire d'électrodes pour détecter une variation de résistance dans ce film à effet de magnétorésistance, chaque ensemble détectant des signaux enregistrés sur une pluralité de pistes respectives du support d'enregistrement magnétique et ayant un axe d'aimantation facile dans ledit film à effet de magnétorésistance qui est sensiblement orthogonal à la direction de largeur desdites pistes.

4. Tête magnétique selon la revendication 1 ou tête magnétique de type composite selon la revendication 2, dans laquelle la couche conductrice a une épaisseur de 1,8 à 2,8 nanomètres.

5. Tête magnétique selon la revendication 1 ou tête magnétique de type composite selon la revendication 2, incluant une couche de polarisation magnétique douce (33) et une paire d'électrodes (39a, 39a', 39b, 39b', 39c, 39c') pour appliquer un courant électrique à cette couche de polarisation magnétique douce pour qu'on puisse appliquer un champ magnétique de polarisation à la couche à effet de magnétorésistance.

FIG. 1

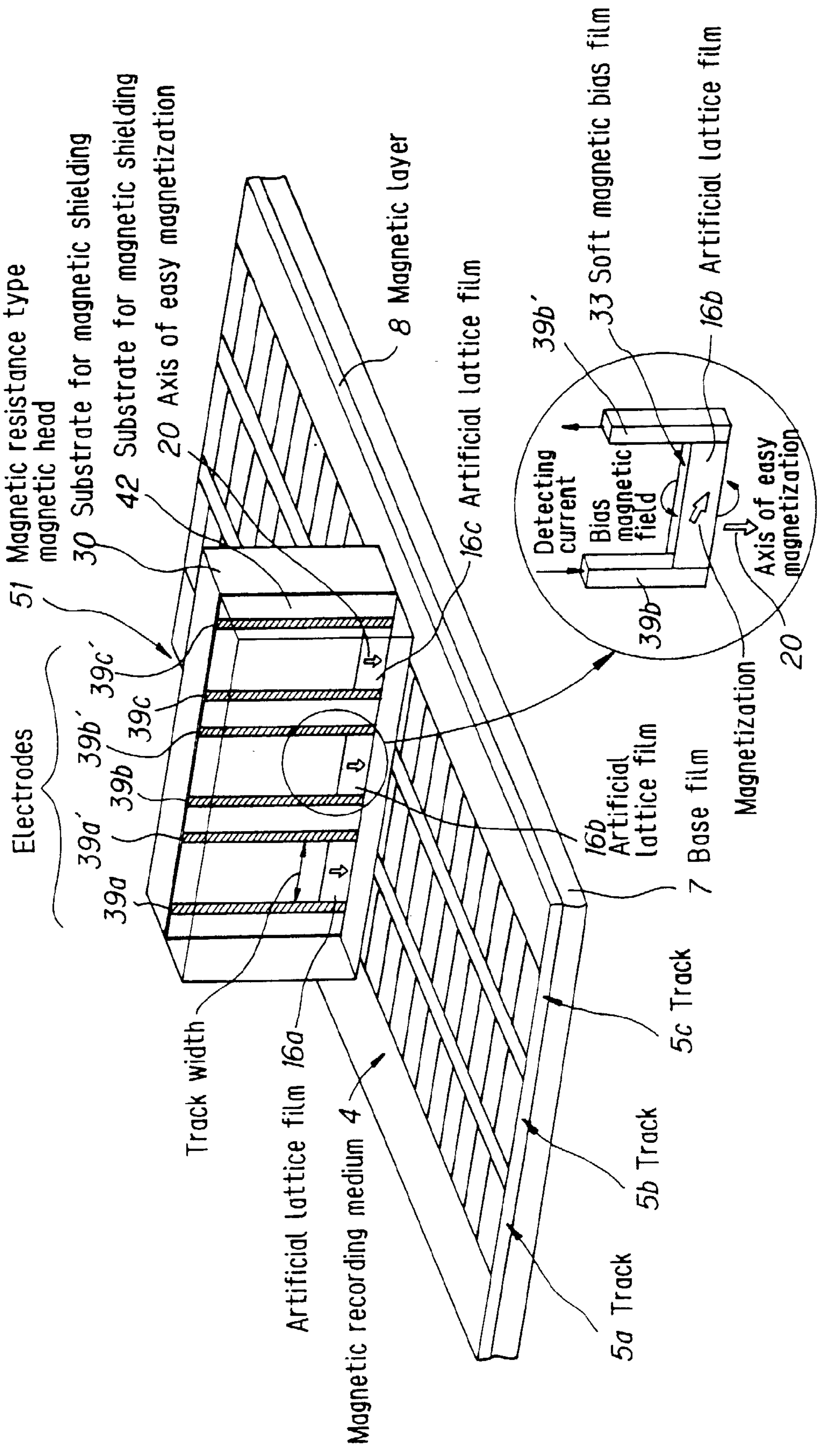

Electrodes
39a
39a'
39b
39b'
39c
39c'
51 Magnetic resistance type magnetic head
30 Substrate for magnetic shielding
42 Substrate for magnetic shielding
20 Axis of easy magnetization
8 Magnetic layer
16c Artificial lattice film
39b'
33 Soft magnetic bias film
16b Artificial lattice film
Detecting current
Bias magnetic field
Axis of easy magnetization
39b
20
Magnetization
Artificial lattice film
Base film
16b Artificial lattice film
7 Base film
Track width
Artificial lattice film 16a
Magnetic recording medium 4
5c Track
5b Track
5a Track

FIG.2

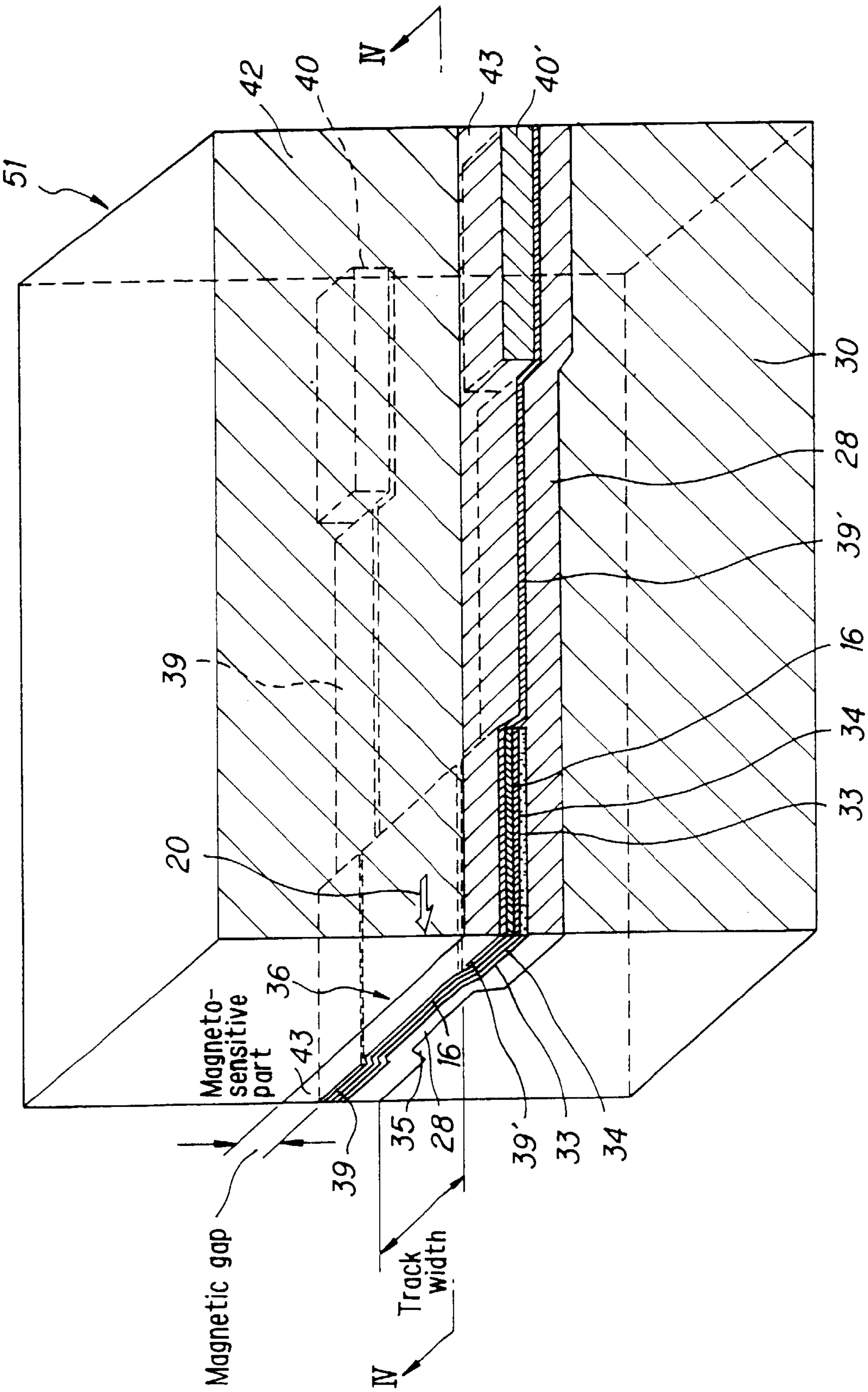
51
42
40
IV
43
40'
30
28
39'
16
34
33
39
20
36
Magneto-sensitive part
43
16
35
28
39
39'
33
34
Magnetic gap
Track width
IV

FIG.3

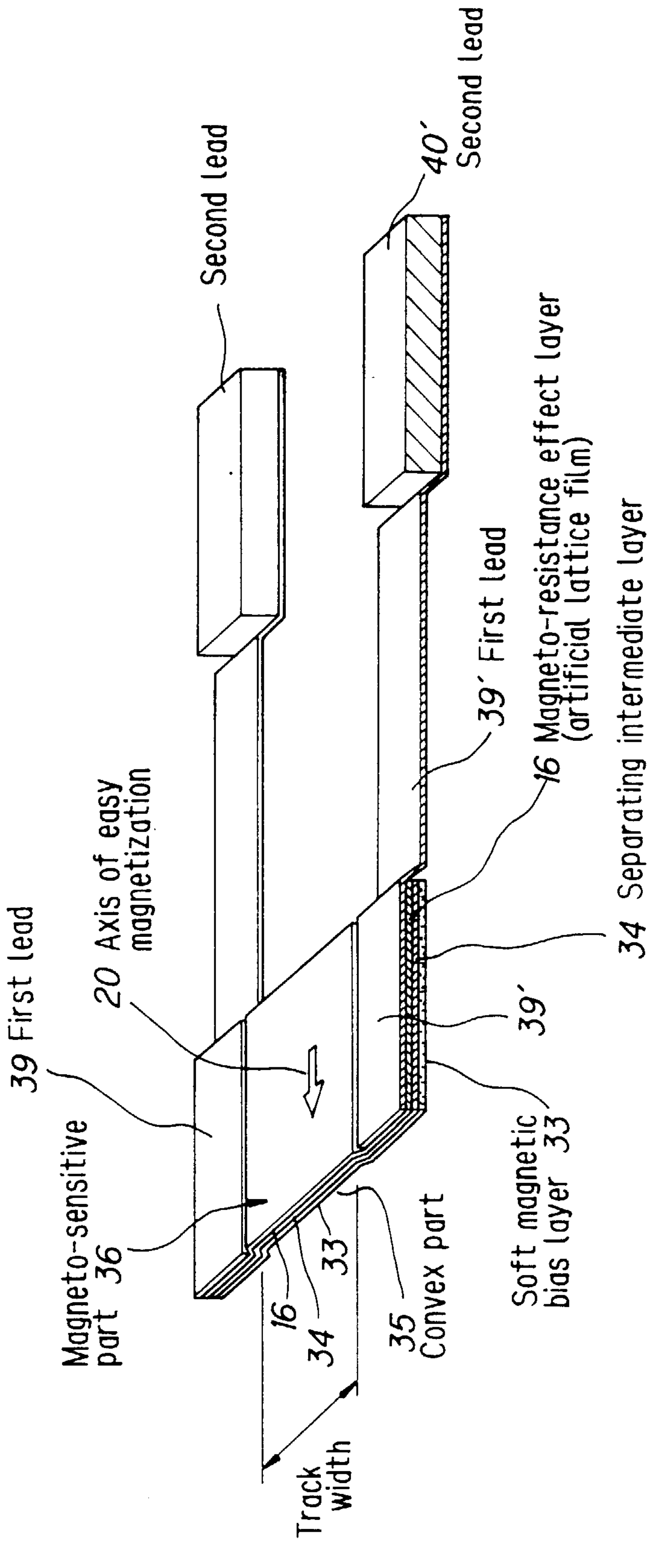

Second lead
40'
Second lead
39 First lead
20 Axis of easy magnetization
Magneto-sensitive part 36
39' First lead
16 Magneto-resistance effect layer (artificial lattice film)
34 Separating intermediate layer
34
39'
Soft magnetic bias layer 33
16
34
33
35 Convex part
Track width

FIG. 4

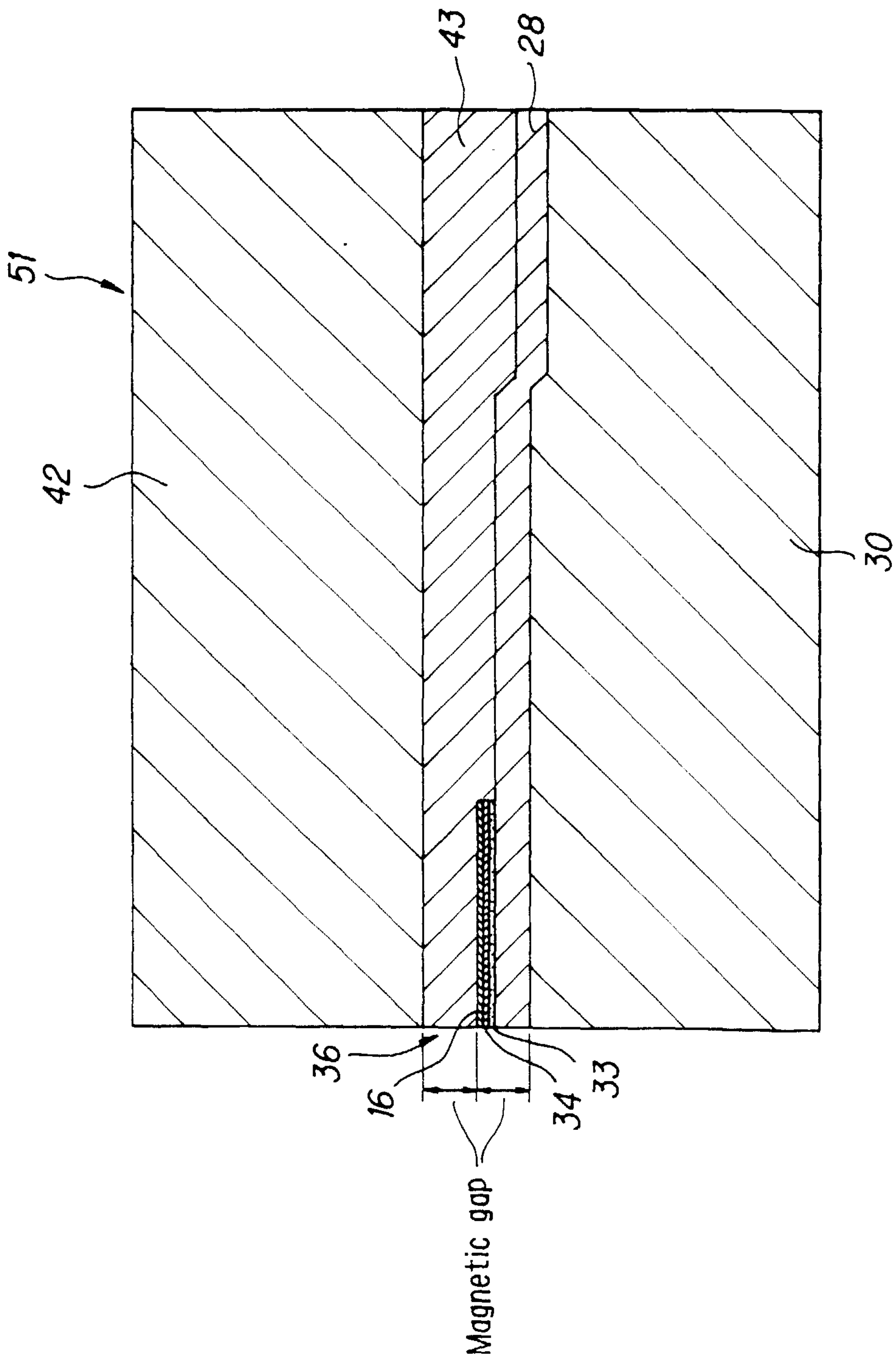

FIG.5

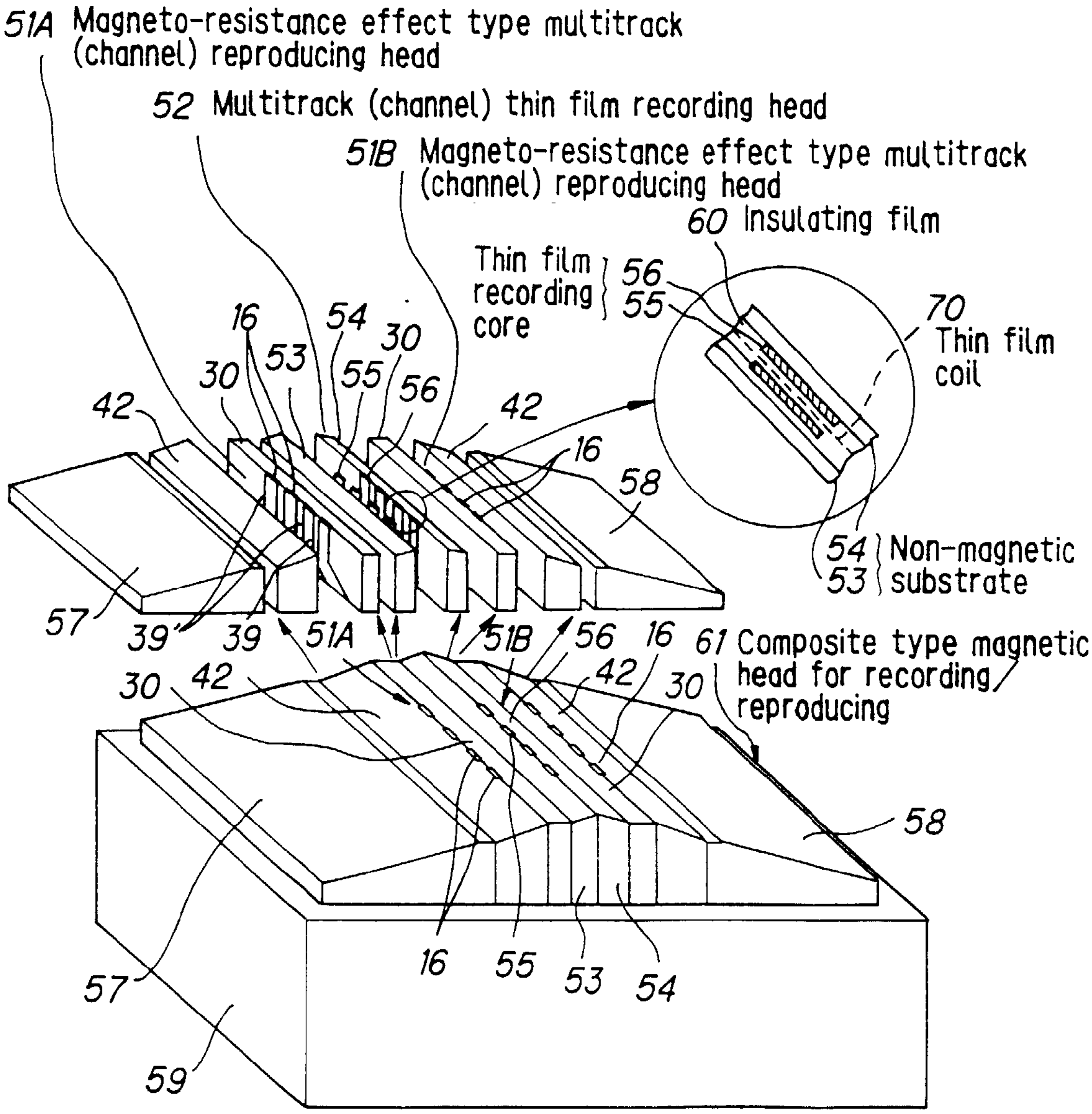


Composite type multitrack (channel) head for recording/reproducing

FIG.6

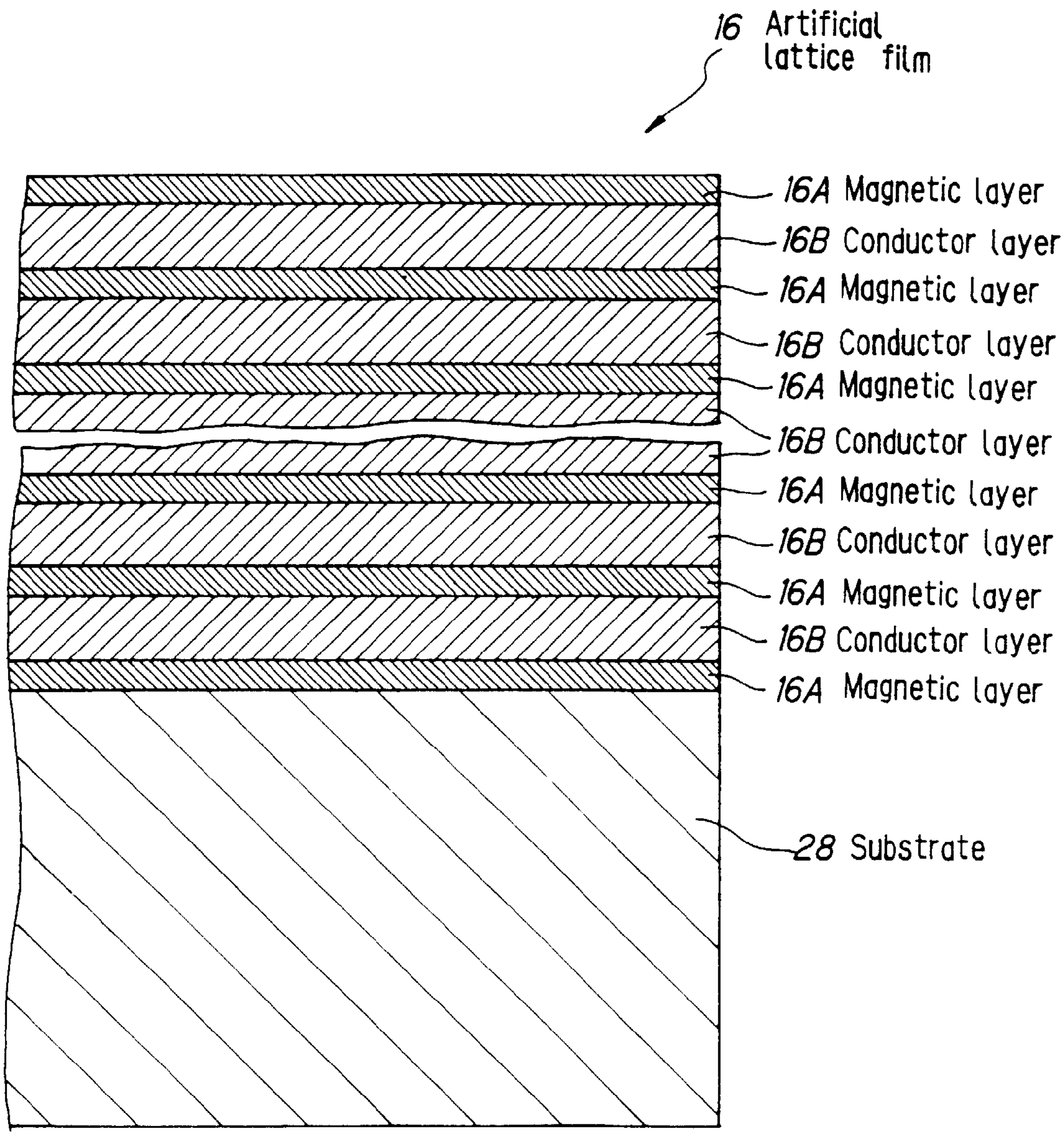
16 Artificial lattice film
16A Magnetic layer
16B Conductor layer
16A Magnetic layer
16B Conductor layer
16A Magnetic layer
16B Conductor layer
16A Magnetic layer
16B Conductor layer
16A Magnetic layer
16B Conductor layer
16A Magnetic layer
28 Substrate

FIG.7

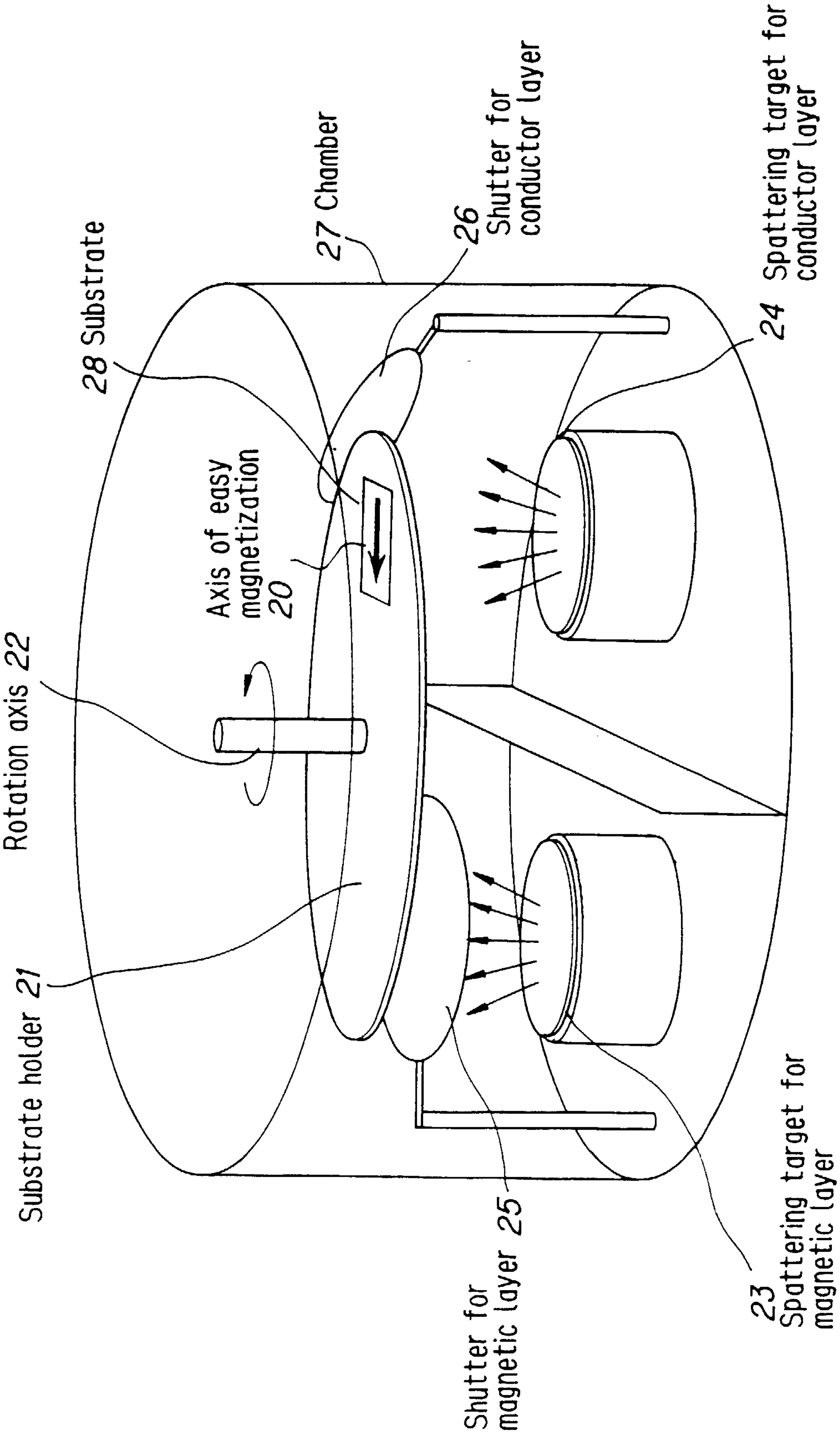

28 Substrate
27 Chamber
26 Shutter for conductor layer
24 Spattering target for conductor layer
Axis of easy magnetization 20
Rotation axis 22
Substrate holder 21
Shutter for magnetic layer 25
23 Spattering target for magnetic layer

FIG.8

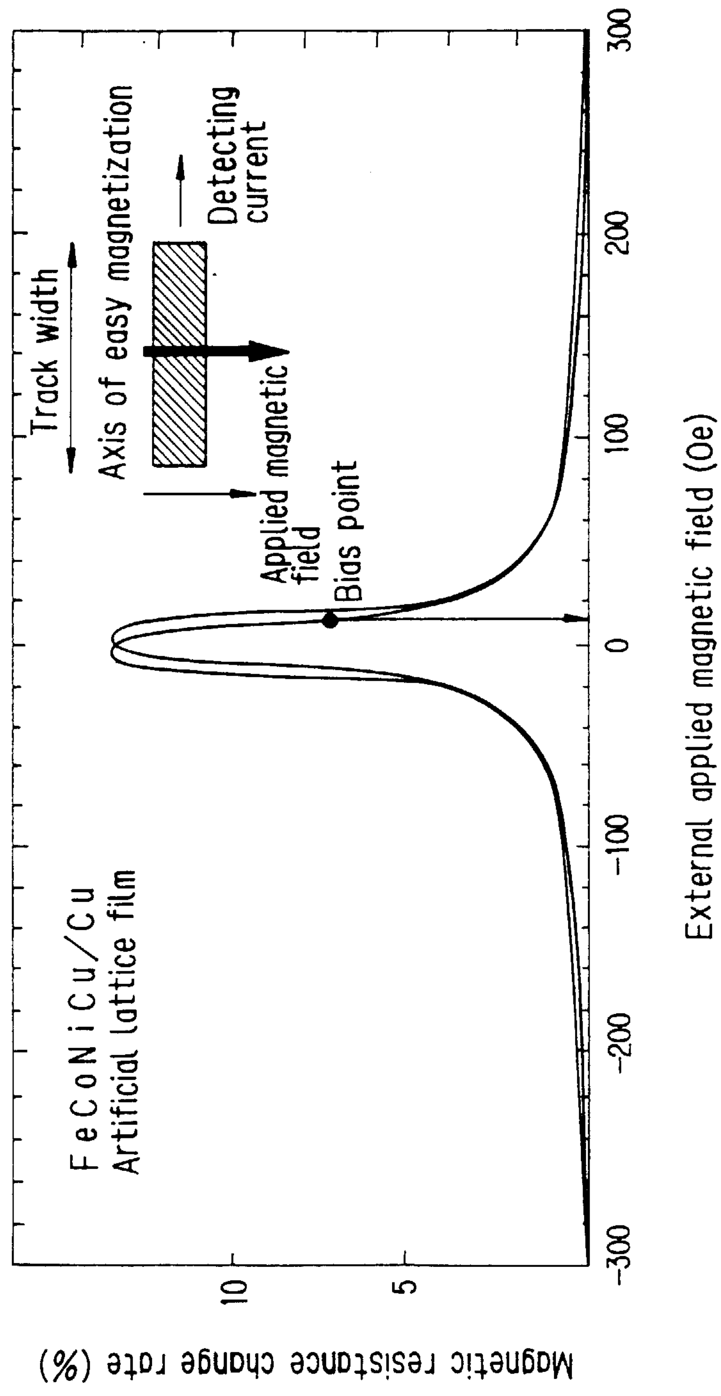
FeCoNiCu/Cu
Artificial lattice film
Track width
Axis of easy magnetization
Detecting current
Applied magnetic field
Bias point
10
5
-300
-200
-100
0
100
200
300
External applied magnetic field (Oe)
Magnetic resistance change rate (%)

FIG. 9

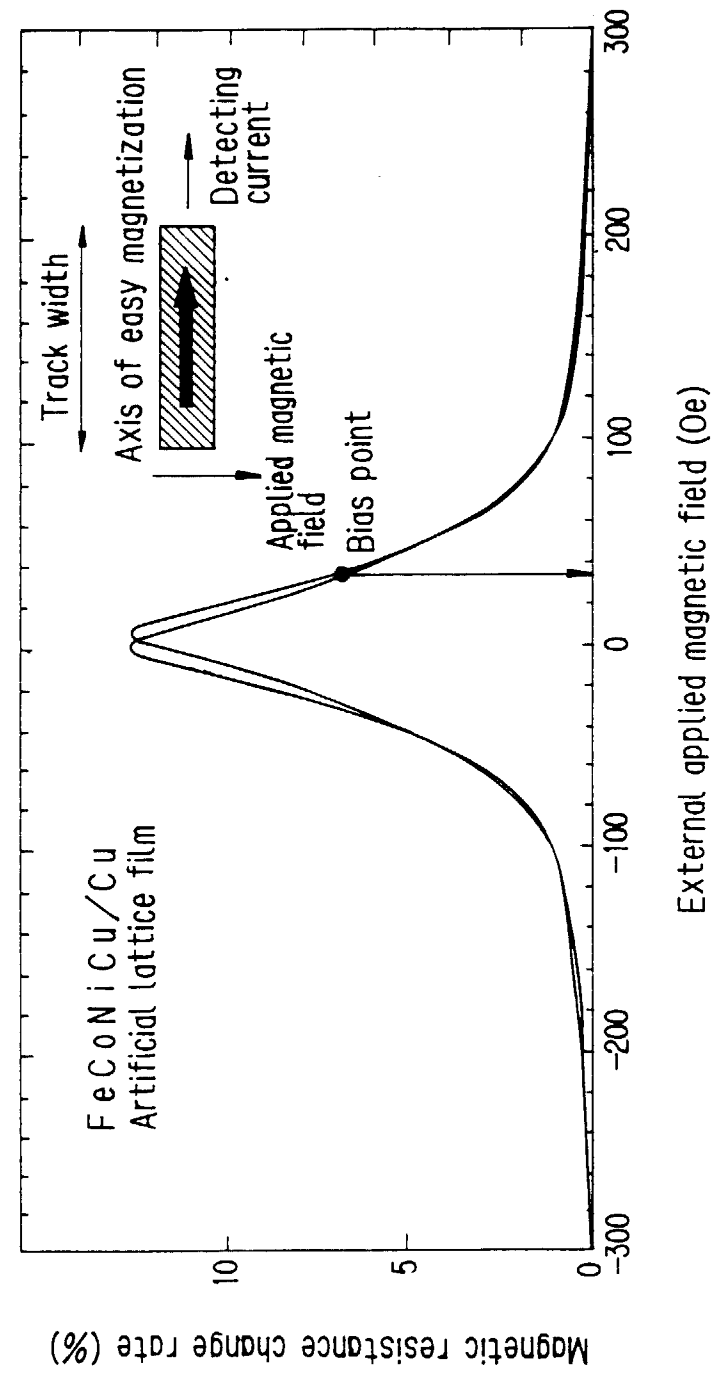
FeCoNiCu/Cu
Artificial lattice film
Track width
Axis of easy magnetization
Detecting current
Applied magnetic field
Bias point
Magnetic resistance change rate (%)
0
5
10
-300
-200
-100
0
100
200
300
External applied magnetic field (Oe)

FIG. 10

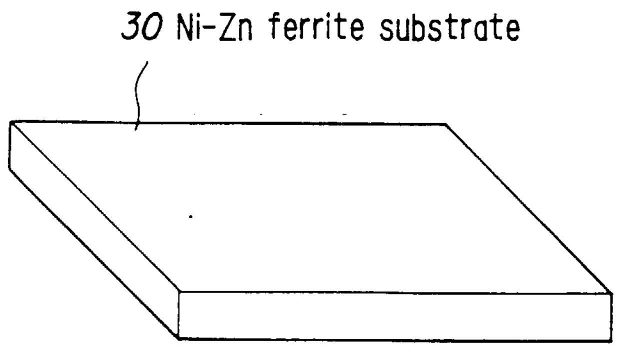
30 Ni-Zn ferrite substrate

FIG. 11

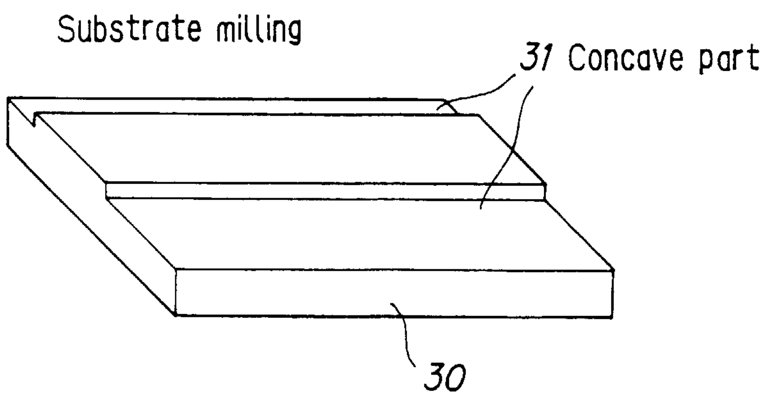
Substrate milling
31 Concave part
30

FIG. 12

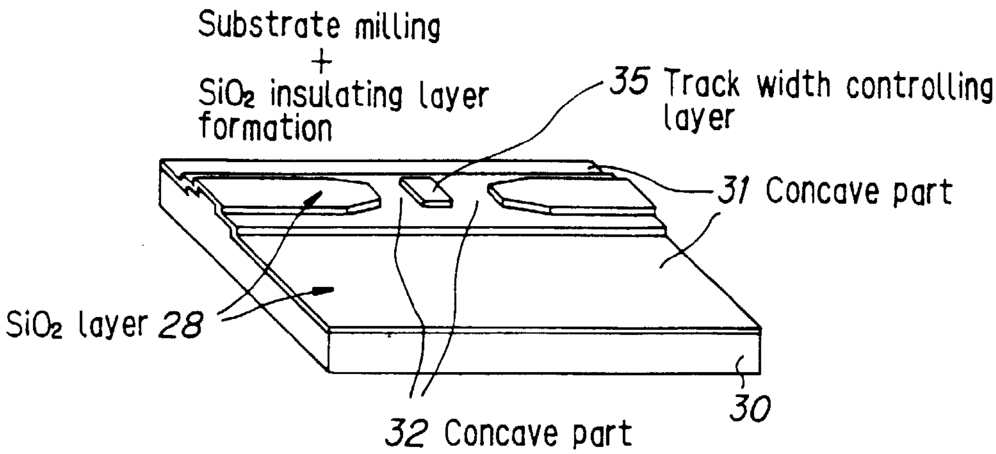
Substrate milling
+
SiO2 insulating layer formation
35 Track width controlling layer
31 Concave part
SiO2 layer 28
30
32 Concave part

FIG. 13

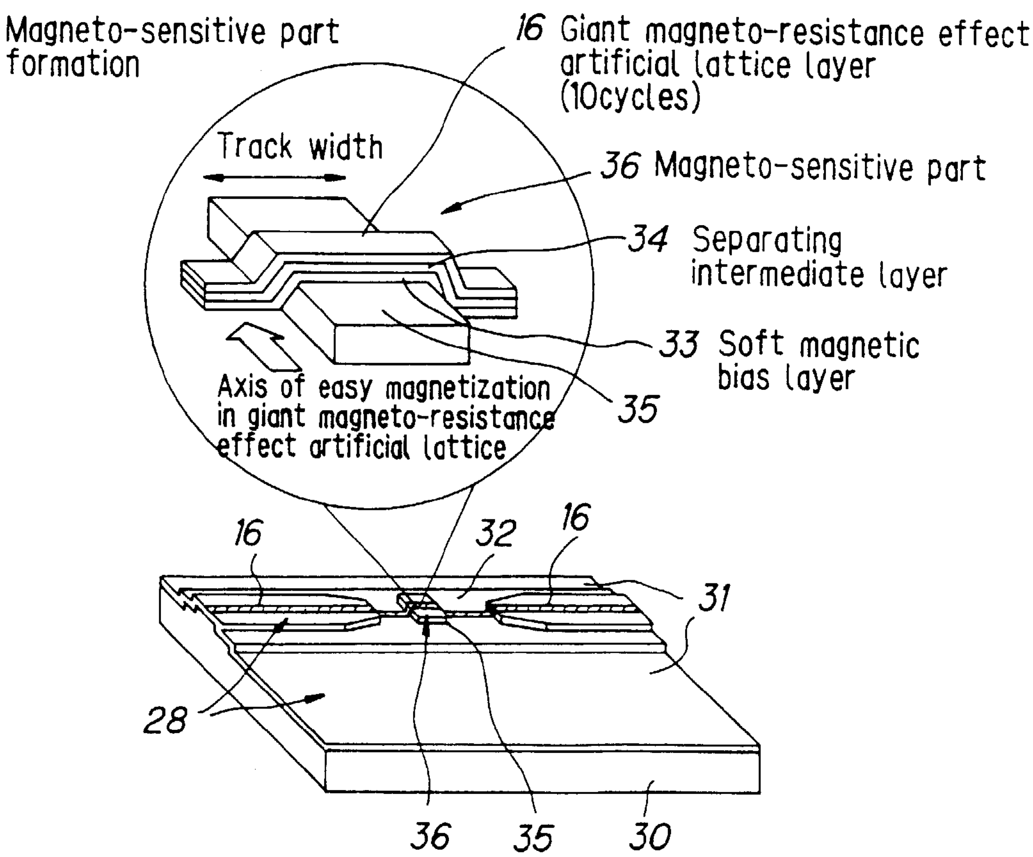
Magneto-sensitive part formation
16 Giant magneto-resistance effect artificial lattice layer (10cycles)
Track width
36 Magneto-sensitive part
34 Separating intermediate layer
33 Soft magnetic bias layer
35
Axis of easy magnetization in giant magneto-resistance effect artificial lattice
16
32
16
31
28
36
35
30

FIG. 14

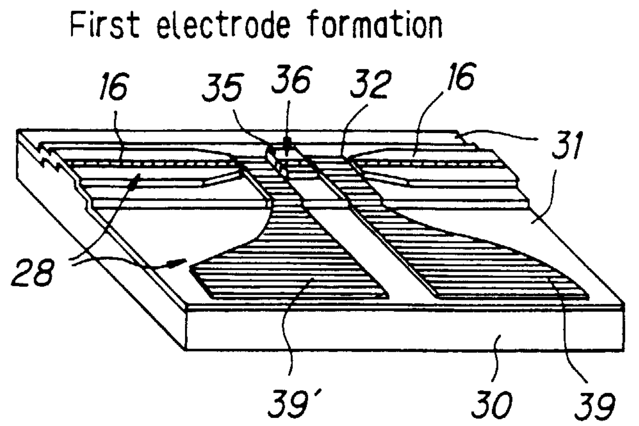
First electrode formation
16
35
36
32
16
31
28
39'
30
39

FIG. 15

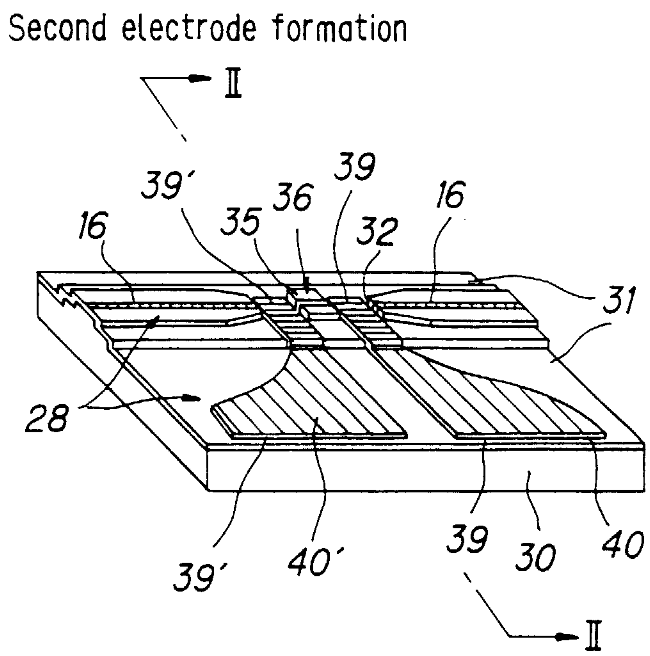
Second electrode formation
II
39'
16
35
36
39
32
16
31
28
39'
40'
39
30
40
II

FIG. 16

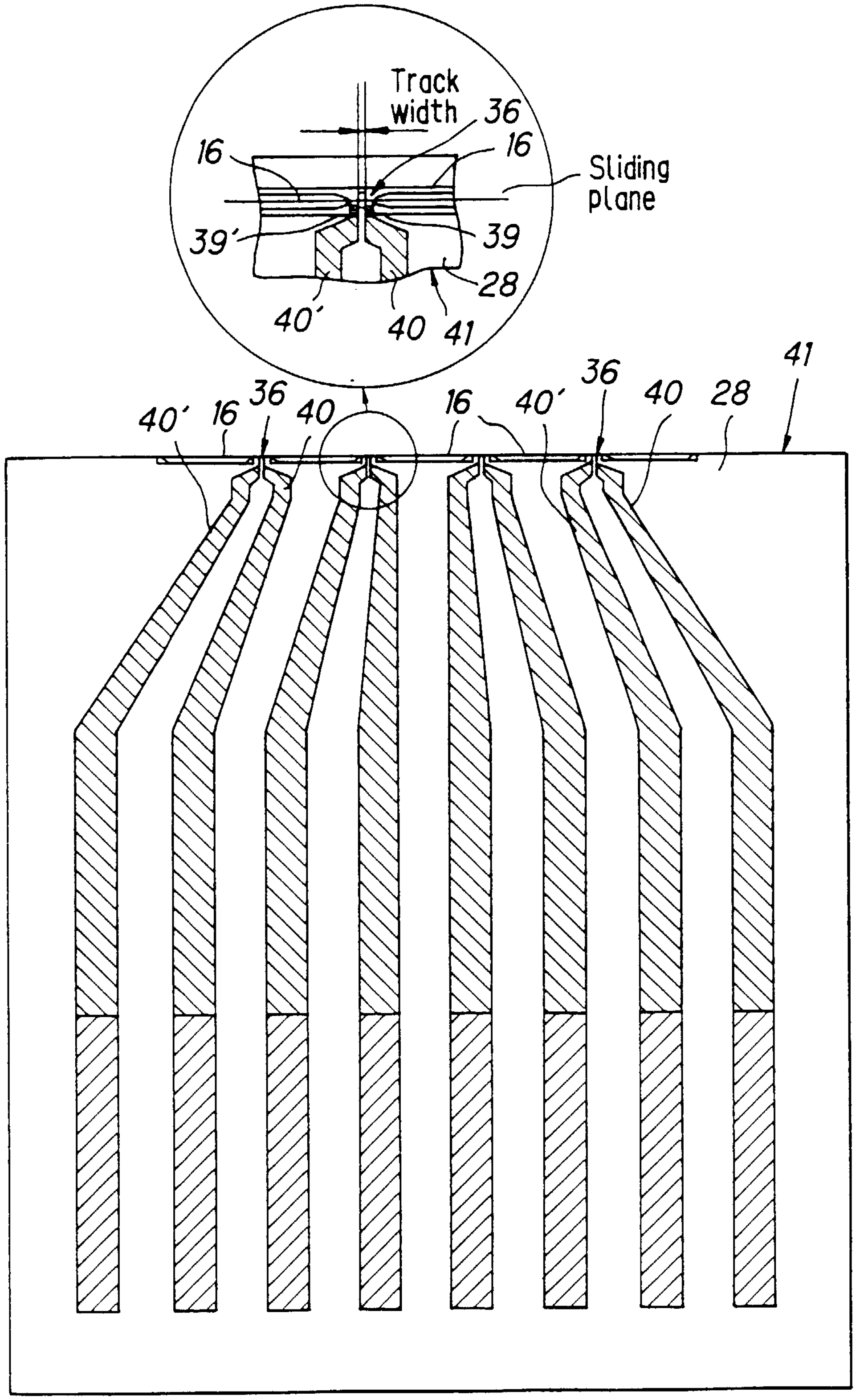
Track
width
36
16
16
Sliding
plane
39'
39
28
40'
40
41
41
40'
16
36
40
16
40'
36
40
28

FIG. 17

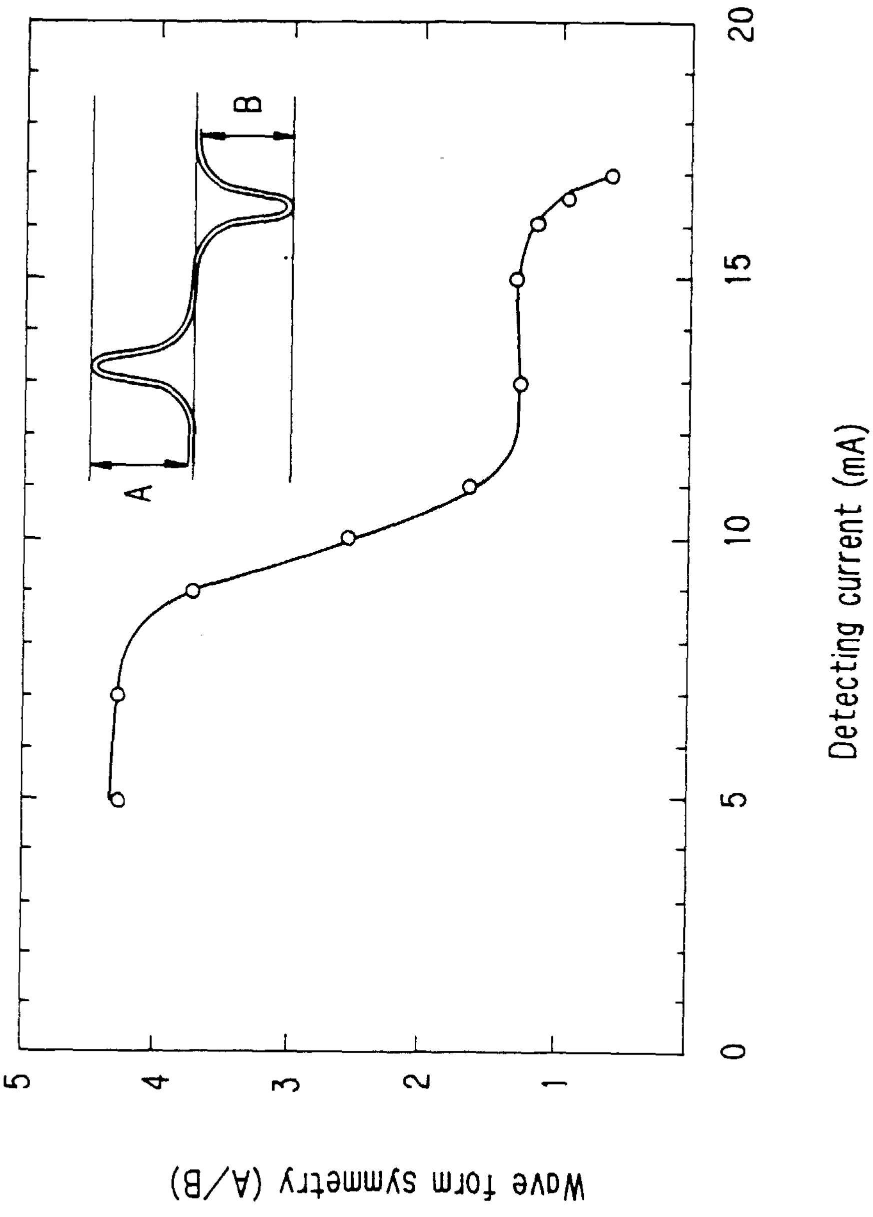

Wave form symmetry (A/B)
Detecting current (mA)
A
B
0
5
10
15
20
1
2
3
4
5

FIG. 18

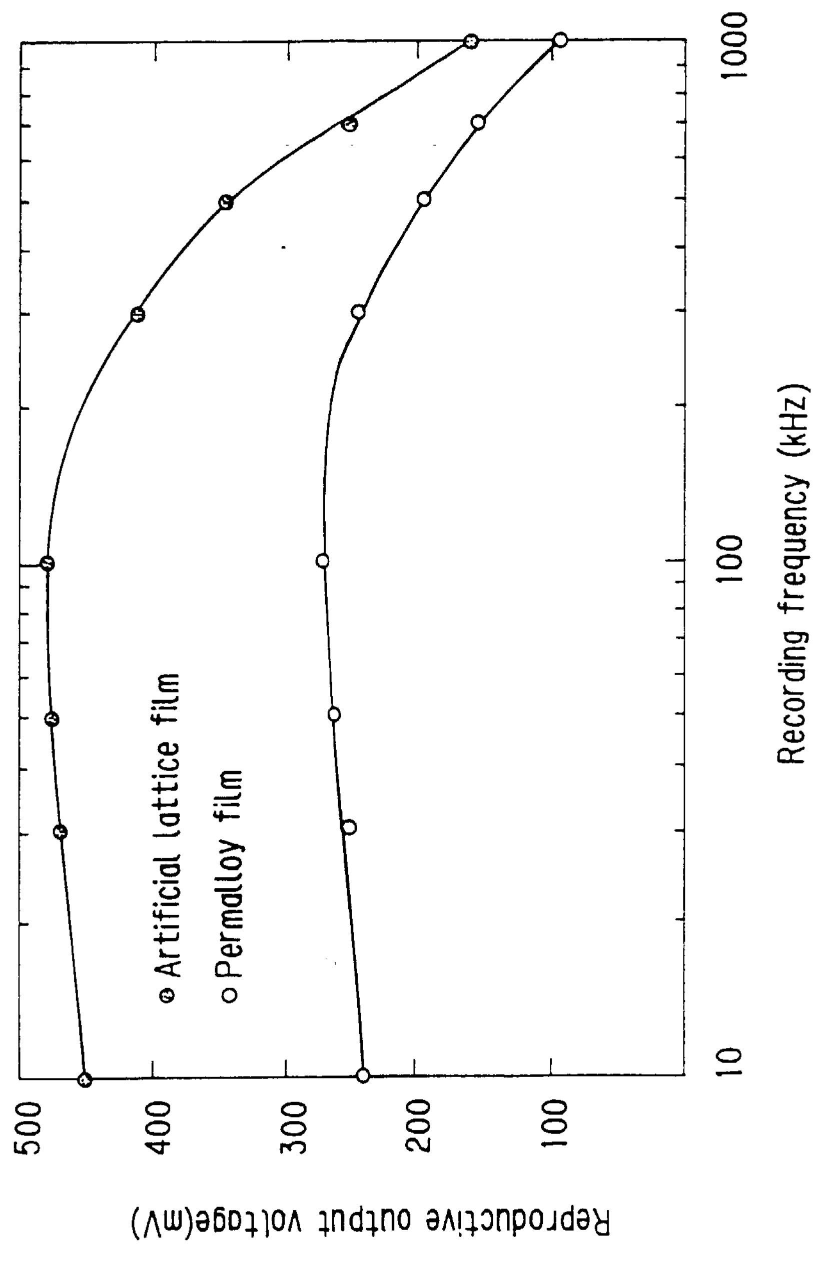
Artificial lattice film
Permalloy film
Reproductive output voltage(mV)
Recording frequency (kHz)
500
400
300
200
100
10
100
1000

FIG. 19

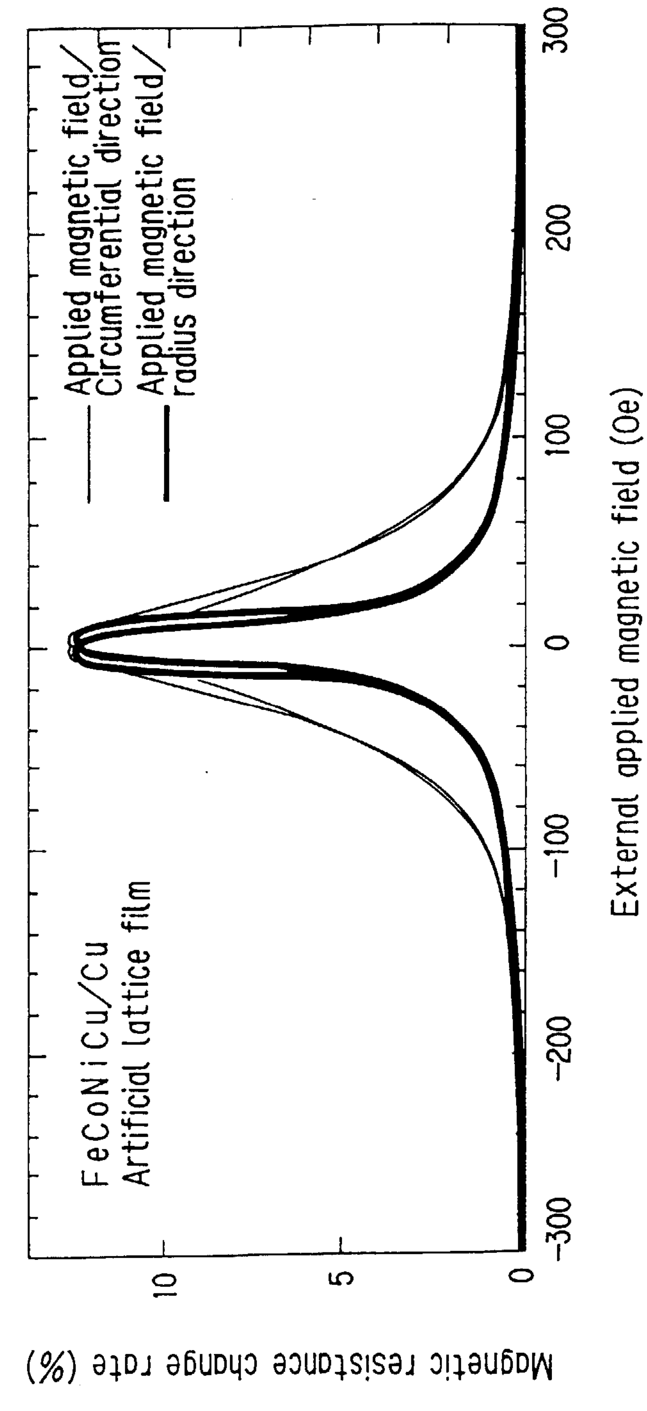
FeCoNiCu/Cu
Artificial lattice film
Applied magnetic field/
Circumferential direction
Applied magnetic field/
radius direction
Magnetic resistance change rate (%)
0
5
10
-300
-200
-100
0
100
200
300
External applied magnetic field (Oe)

FIG. 20

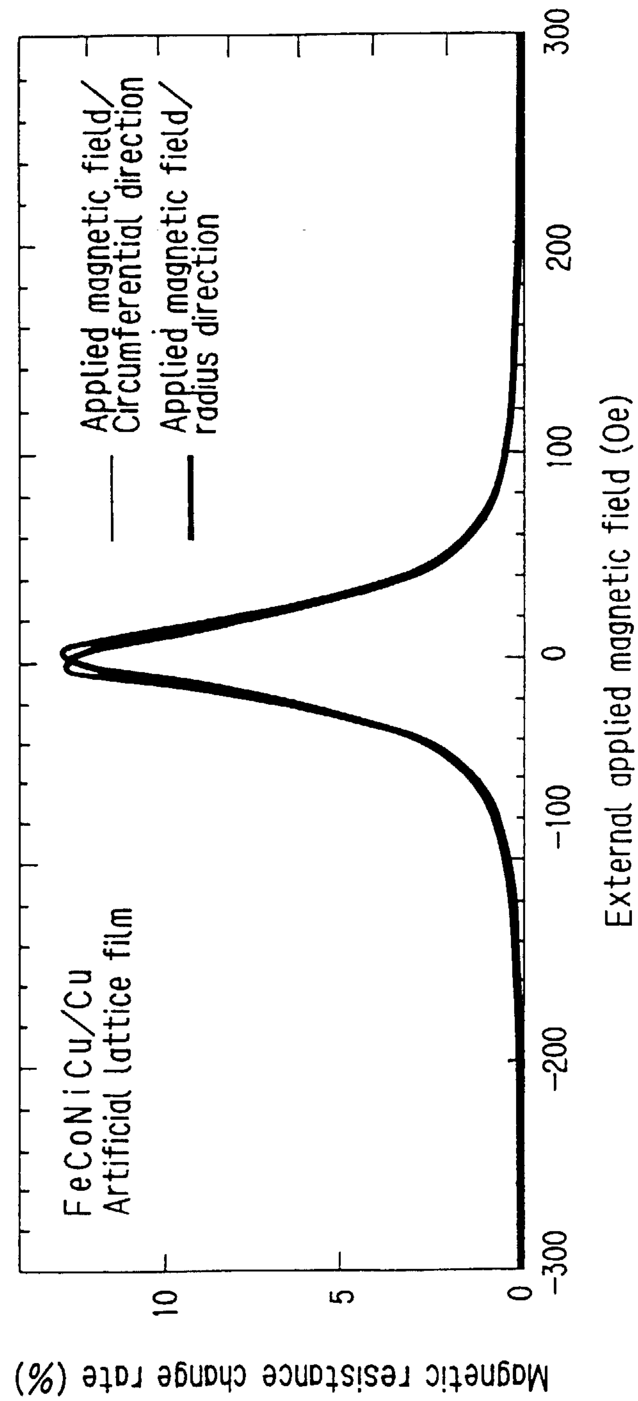

FeCoNiCu/Cu
Artificial lattice film
Applied magnetic field/
Circumferential direction
Applied magnetic field/
radius direction
Magnetic resistance change rate (%)
10
5
0
-300
-200
-100
0
100
200
300
External applied magnetic field (Oe)

FIG.21

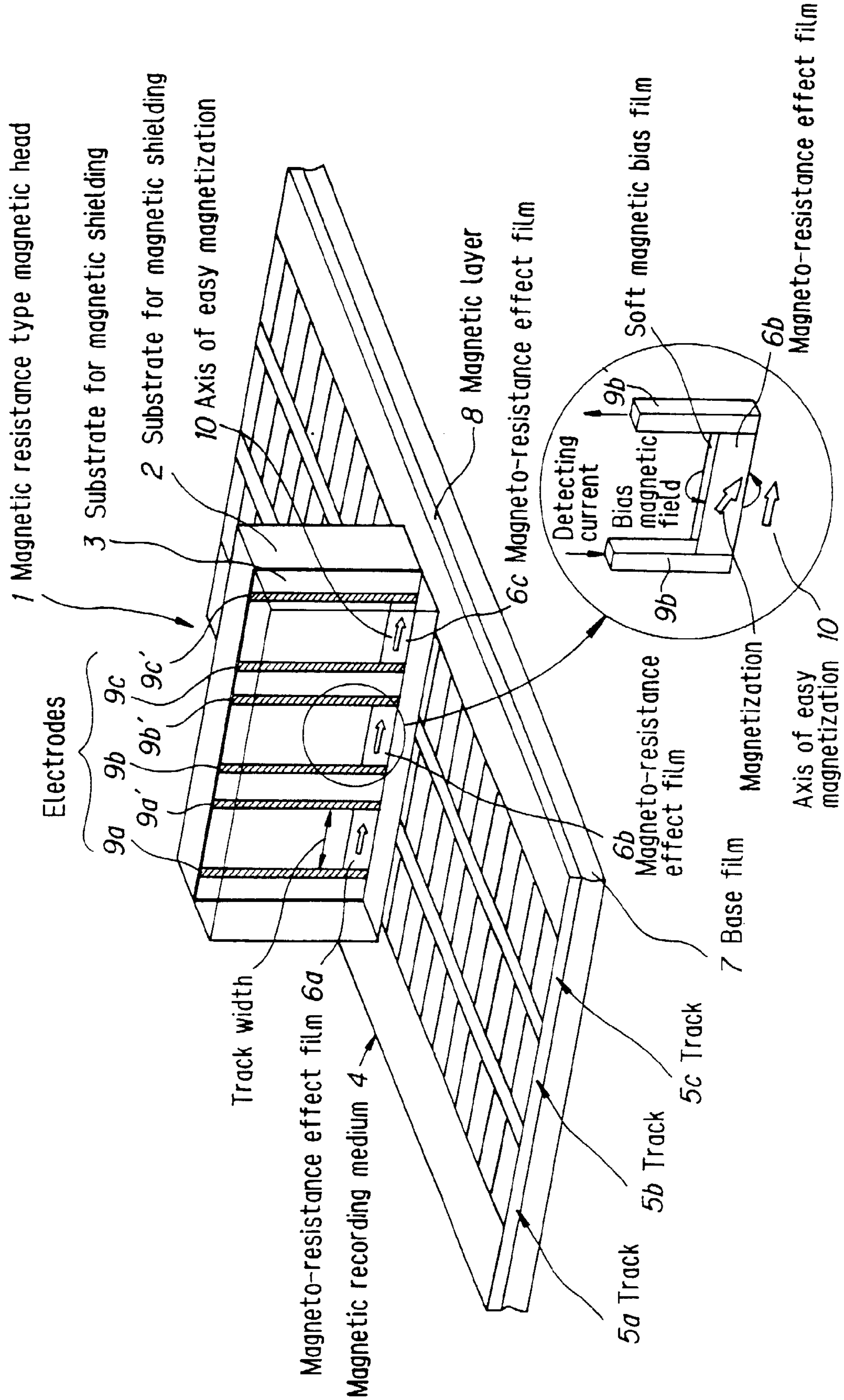
1 Magnetic resistance type magnetic head
3 Substrate for magnetic shielding
2 Substrate for magnetic shielding
10 Axis of easy magnetization
8 Magnetic layer
6c Magneto-resistance effect film
Electrodes
9a 9b 9c
9a' 9b' 9c'
Track width
Magneto-resistance effect film 6a
Magnetic recording medium 4
5a Track
5b Track
5c Track
7 Base film
6b Magneto-resistance effect film
Detecting current
Bias magnetic field
9b
9b'
Soft magnetic bias film
6b Magneto-resistance effect film
Magneto-resistance effect film
Magnetization
Axis of easy magnetization 10

FIG.22

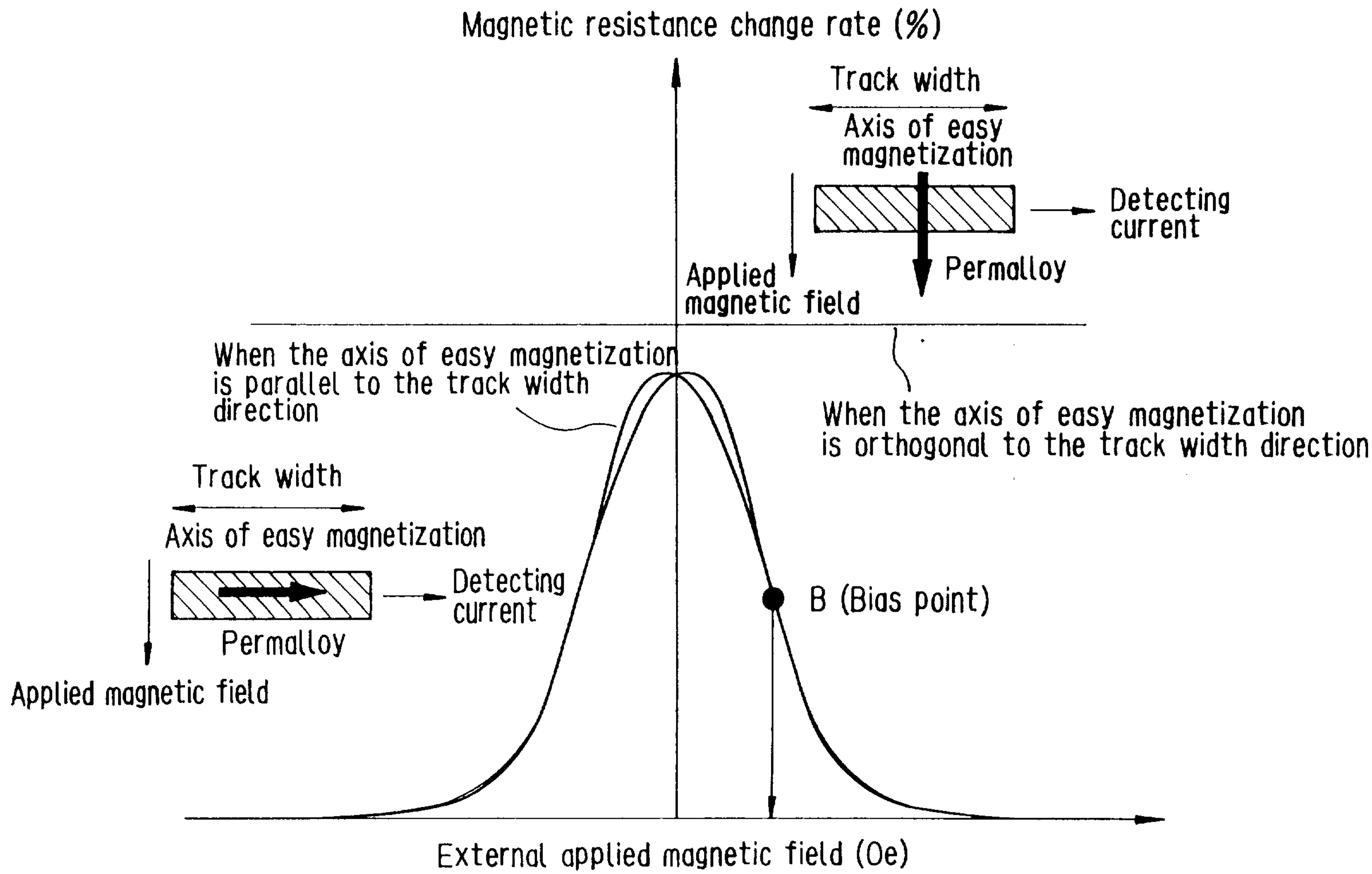
Magnetic resistance change rate (%)
Track width
Axis of easy magnetization
Detecting current
Permalloy
Applied magnetic field
When the axis of easy magnetization is parallel to the track width direction
When the axis of easy magnetization is orthogonal to the track width direction
Track width
Axis of easy magnetization
Detecting current
Permalloy
Applied magnetic field
B (Bias point)
External applied magnetic field (Oe)